# EUROPEAN PATENT SPECIFICATION

(11) **EP 4 071 945 B1**
(45) Date of publication and mention of the grant of the patent: **26.03.2025**
(21) Application number: 20913120.0
(22) Date of filing: 28.12.2020
(51) Int. Cl.: H01S 5/026, H01L 27/15, H01S 5/183

(54) **SEMICONDUCTOR DEVICE**
HALBLEITERBAUELEMENT
DISPOSITIF À SEMI-CONDUCTEURS

(30) Priority: 13.01.2020 US 202062960581 P
(43) Date of publication of application: 12.10.2022
(73) Proprietor: Nuvoton Technology Corporation Japan, Nagaokakyo City Kyoto 617-8520 (JP)
(72) Inventor: YAMAMOTO, Kouki, Nagaokakyo City, Kyoto 617-8520 (JP); AKIYOSHI, Shinichi, Nagaokakyo City, Kyoto 617-8520 (JP); TANIOKU, Masatoshi, Nagaokakyo City, Kyoto 617-8520 (JP); TAKATA, Haruhisa, Nagaokakyo City, Kyoto 617-8520 (JP)
(74) Representative: Novagraaf International SA
(86) International application number: PCT/JP2020/049117
(87) International publication number: WO 2021/145217

(56) References cited:
- WO-A1-2018/188910
- WO-A1-2019/202874
- DE-A1- 102017 112 101
- JP-A- 2007 164 173
- JP-A- 2012 151 323
- JP-A- 2019 067 831
- JP-A- 2019 140 151
- JP-A- H11 121 735
- US-A1- 2004 032 888
- US-A1- 2018 278 011
- US-A1- 2018 278 017

## Description

### [Technical Field]

The present disclosure relates to a semiconductor device, and particularly to a semiconductor device suitable for improving distance measurement accuracy in a light source module for distance measurement.

### [Background Art]

A known light source module for distance measurement includes a light-emitting element and a switching element that controls current conduction to the light-emitting element (see Patent Literature (PTL) 1).

### [Citation List]

### [Patent Literature]

[PTL 1] U.S. Patent Application Publication No. 2020/0185875. Further prior art is disclosed in US2018278011.

### [Summary of Invention]

### [Technical Problem]

A distance measurement function using a light source module including a light-emitting element and a switching element that controls current conduction to the light-emitting element, and space recognition technology using a distance measurement function, are beginning to be used for many purposes. In a Time of Flight (ToF) method that is one of distance measurement techniques using a light source module, a distance to an object is measured by irradiating the object at a distance with light emitted from a light source module on which pulse conduction is performed at high frequencies, and measuring time taken by the light to be reflected from the object. In order to improve distance measurement accuracy, each waveform of pulsed light is required to be an ideal square shape with a steep rise. Moreover, a light source module needs to include not only a light-emitting element but also a switching element that controls pulse conduction and a bypass capacitor that supplies electric charges to these elements. The light source module further needs metal wirings that electrically connect those elements. It is known that parasitic inductance inherently unintended by design occurs in a conduction path. When parasitic inductance is large, it is difficult to achieve a square waveform with a steep rise required for pulsed light.

The present disclosure has been made in view of the above problem, and has an object to reduce parasitic inductance of a light source module so that a waveform of pulsed light from the light source module is a square shape with a steep rise.

### [Solution to Problem]

A semiconductor device of a hybrid type according to one aspect of the present disclosure includes: a light-emitting element; a semiconductor integrated circuit element including a switching element that is connected in series with the light-emitting element and controls current conduction to the light-emitting element in response to a control signal externally inputted; and a bypass capacitor that supplies electric charges to the light-emitting element and the semiconductor integrated circuit element. The light-emitting element, the semiconductor integrated circuit element, and the bypass capacitor form a power loop. The light-emitting element and the switching element constitute a layered body in which respective principal surfaces of the light-emitting element and the switching element are layered in parallel and face-to-face. The layered body is mounted on a mounting board. When, of the light-emitting element and the switching element constituting the layered body, one element mounted on the mounting board is a lower element, and an other element mounted on the lower element is an upper element, the bypass capacitor includes one electrode connected to the lower element and an other electrode connected to the upper element. In a plan view of the semiconductor device, when a direction from the one electrode to the other electrode inside the bypass capacitor is a first direction, the bypass capacitor is arranged so that a side of the bypass capacitor parallel to the first direction includes a portion that is parallel to and faces one peripheral side of the layered body. The invention is as defined in the appended claims only.

### [Advantageous Effects of Invention]

A semiconductor device (a light source module) according to one aspect of the present disclosure reduces parasitic inductance more than conventional ones and brings a waveform of pulsed light from a light-emitting element close to a square shape with a steep rise.

### [Brief Description of Drawings]

[FIG. 1A]

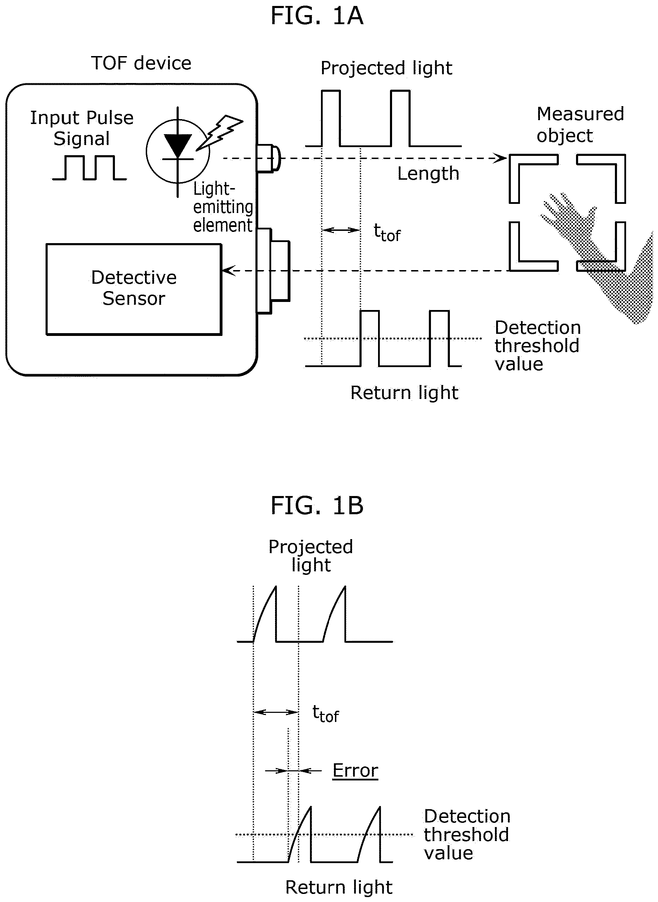

   FIG. 1A is a schematic diagram illustrating the mechanism of a ToF method.
[FIG. 1B]
   FIG. 1B is a schematic diagram illustrating the mechanism of the ToF method.
[FIG. 2A]

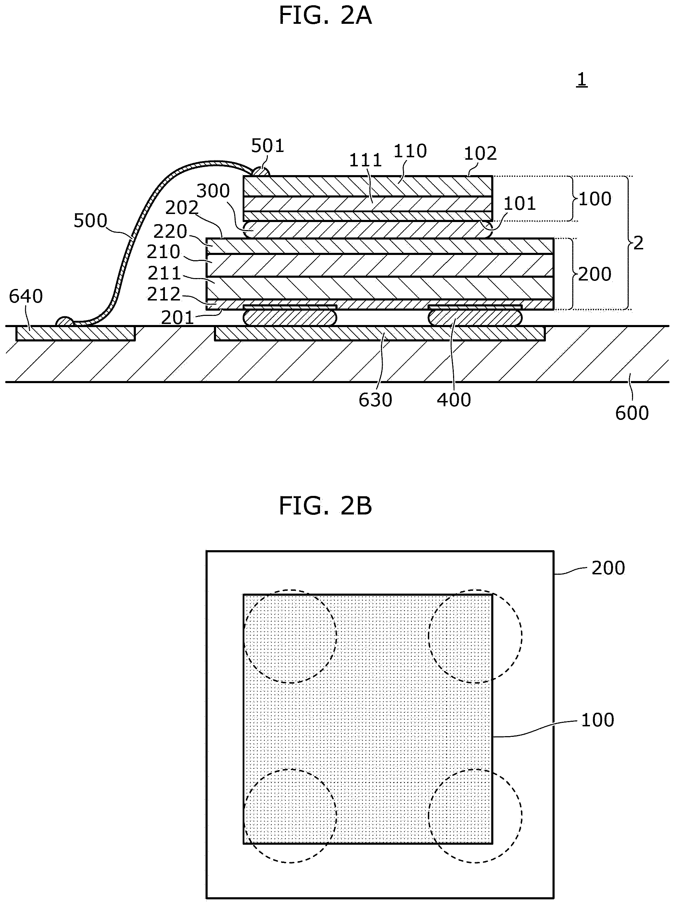

   FIG. 2A is a cross-sectional view of an example of a structure of a semiconductor device according to Embodiment 1.
[FIG. 2B]
   FIG. 2B is a plan view of an example of a structure of a layered body according to Embodiment 1.
[FIG. 2C]

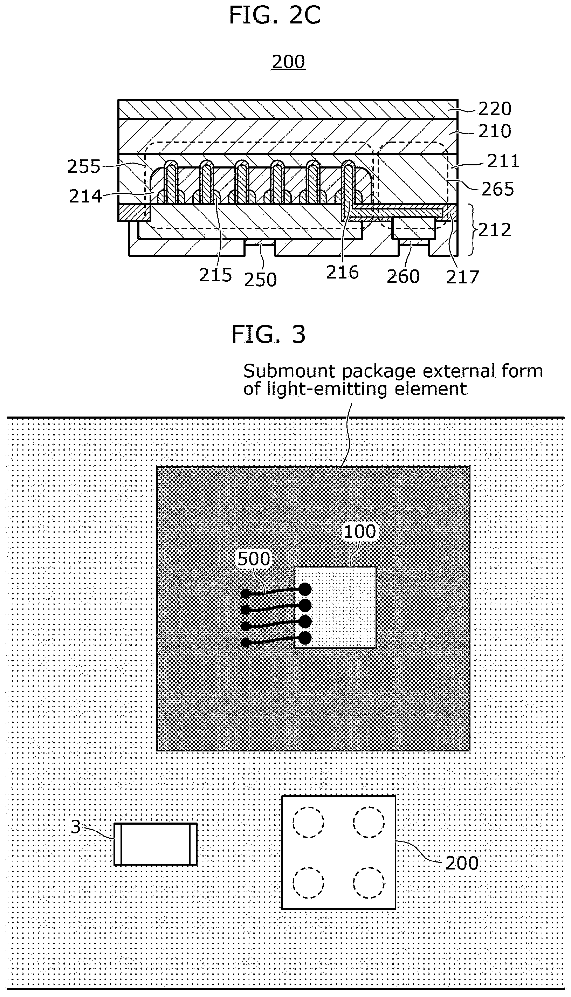

   FIG. 2C is a cross-sectional view of an example of a structure of a switching element according to Embodiment 1.
[FIG. 3]
   FIG. 3 is a plan view of an example of a configuration of a semiconductor device according to Comparative Example 1.
[FIG. 4]

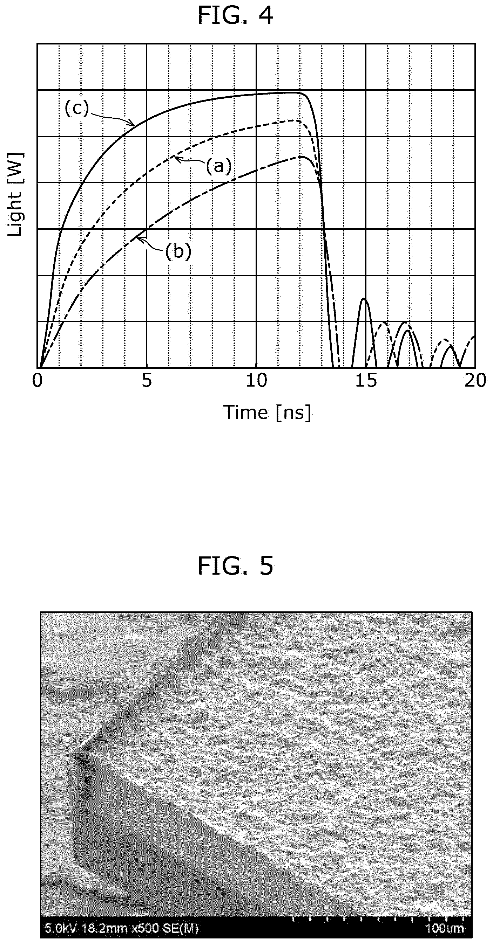

   FIG. 4 is a graph showing waveforms of pulsed light according to the present disclosure and Comparative Example 1.
[FIG. 5]
   FIG. 5 is a perspective image showing an example of a projecting structure provided to the switching element according to Embodiment 1.
[FIG. 6]

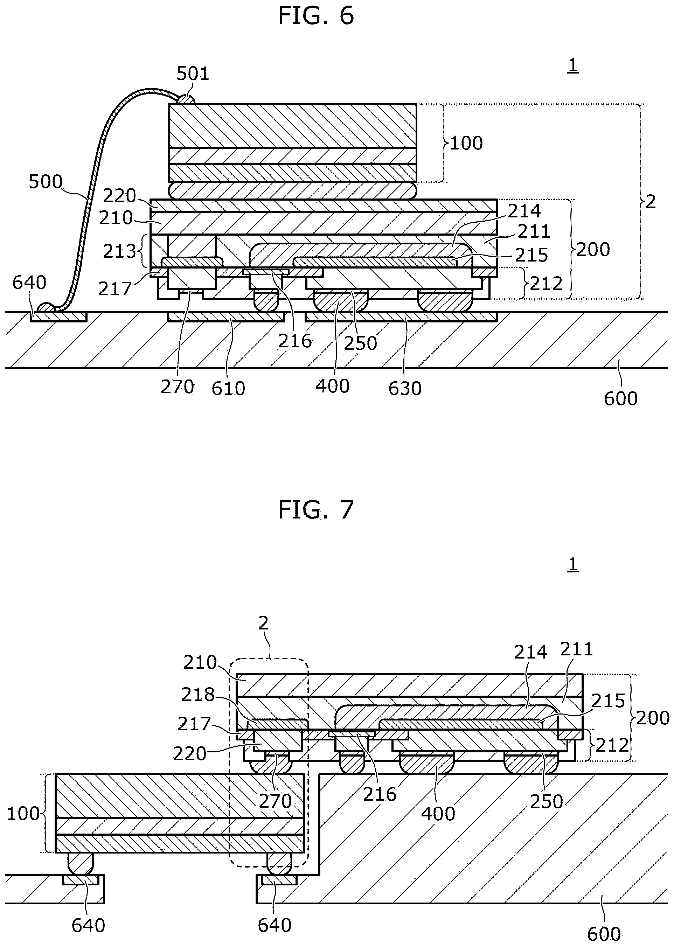

   FIG. 6 is a cross-sectional view of an example of a structure of a semiconductor device according to Embodiment 2.
[FIG. 7]
   FIG. 7 is a cross-sectional view of an example of a structure of a semiconductor device according to Embodiment 3.
[FIG. 8A]

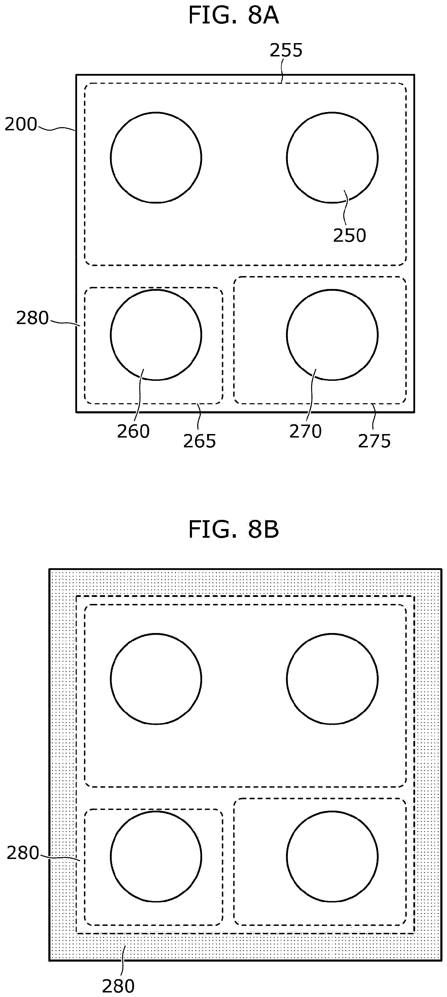

   FIG. 8A is a plan view of an example of a structure of a switching element according to Embodiment 4.
[FIG. 8B]
   FIG. 8B is a plan view of an example of a structure of the switching element according to Embodiment 4.
[FIG. 8C]

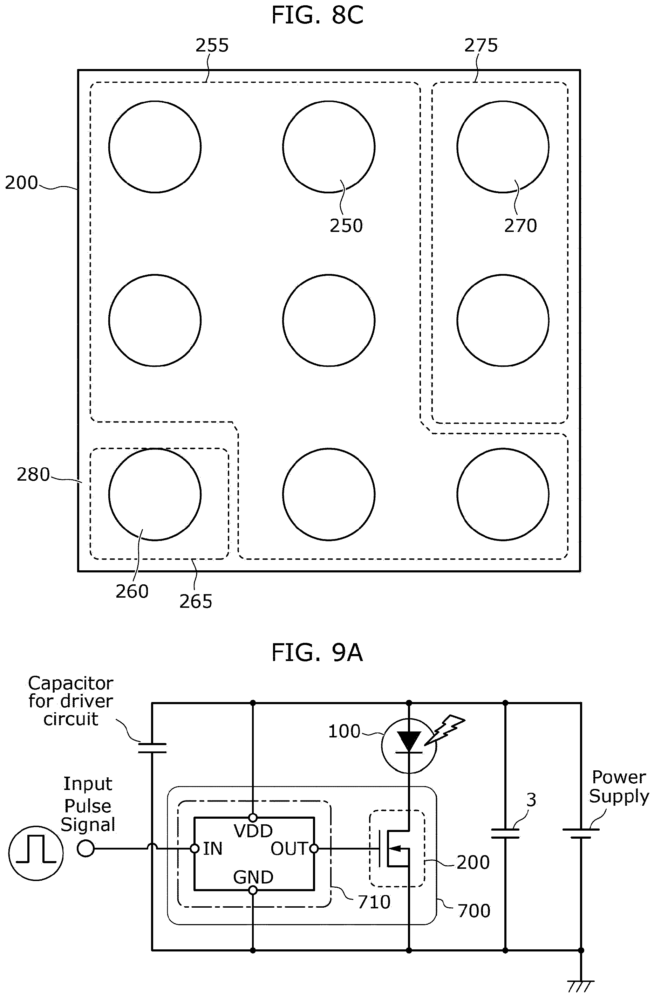

   FIG. 8C is a plan view of an example of a structure of the switching element according to Embodiment 4.
[FIG. 9A]
   FIG. 9A is a diagram illustrating an example of an equivalent circuit of a semiconductor device according to Embodiment 5.
[FIG. 9B]

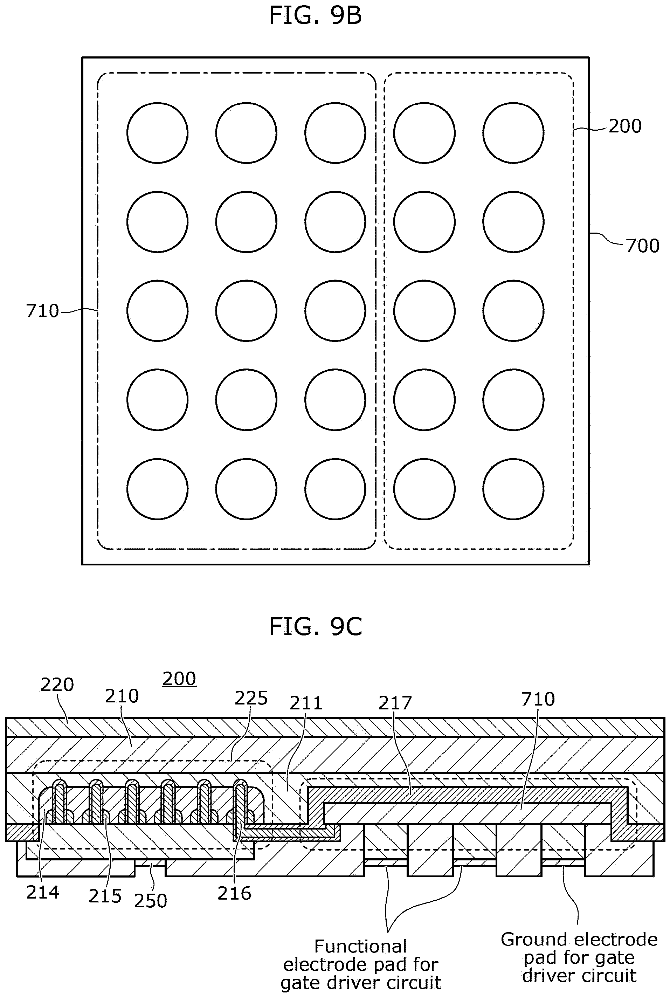

   FIG. 9B is a plan view of an example of a structure of a semiconductor integrated circuit element according to Embodiment 5.
[FIG. 9C]
   FIG. 9C is a cross-sectional view of an example of a structure of the semiconductor integrated circuit element according to Embodiment 5.
[FIG. 10A]

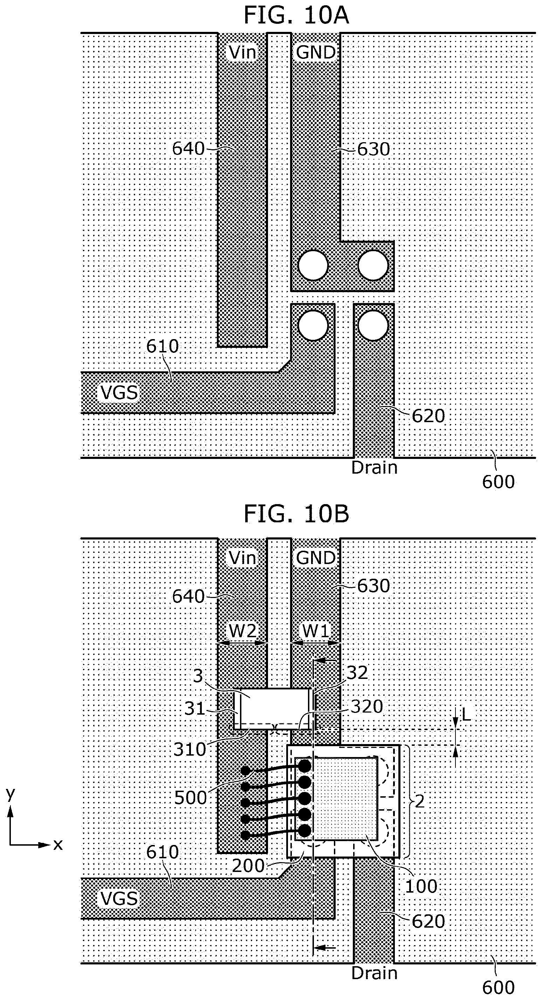

   FIG. 10A is a plan view of an example of a structure of a mounting board before a layered body and a bypass capacitor are arranged in a semiconductor device according to Embodiment 6, which is an embodiment according to the invention.
[FIG. 10B]
   FIG. 10B is a plan view of an example of a structure of the semiconductor device according to Embodiment 6.
[FIG. 10C]

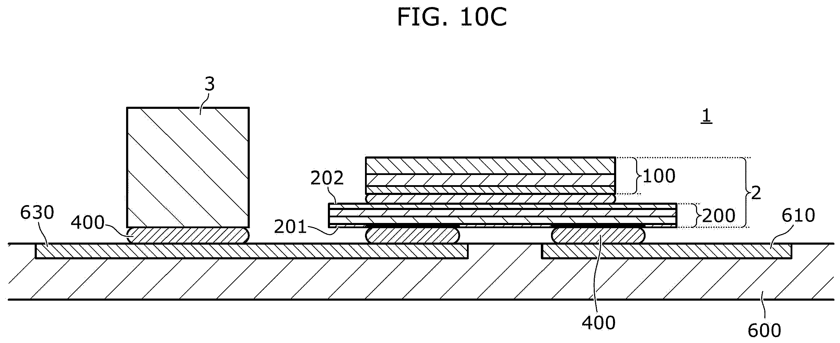

   FIG. 10C is a cross-sectional view of an example of the structure of the semiconductor device according to Embodiment 6.
[FIG. 10D]

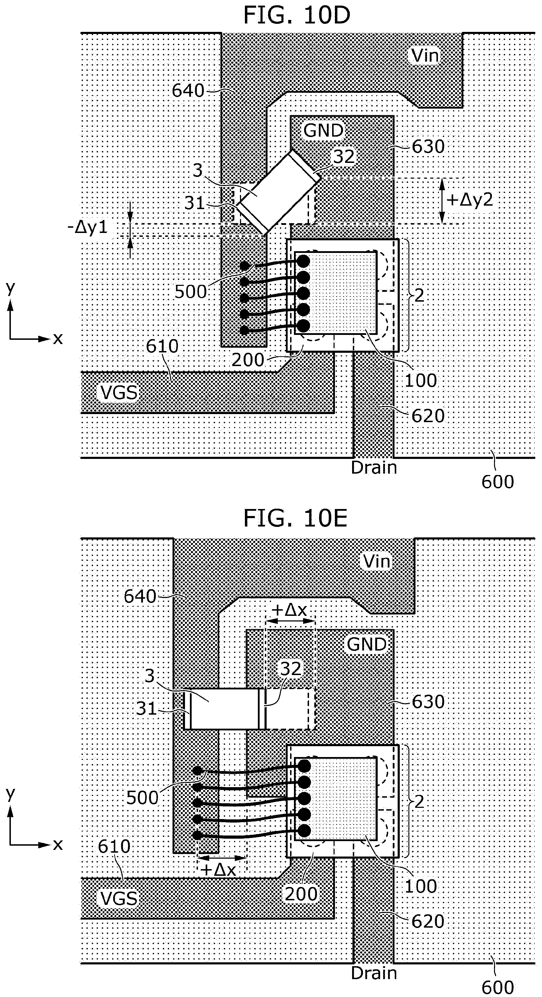

   FIG. 10D is a plan view of a comparative example of the structure of the semiconductor device according to Embodiment 6.
[FIG. 10E]
   FIG. 10E is a plan view of a comparative example of the structure of the semiconductor device according to Embodiment 6.
[FIG. 11A]

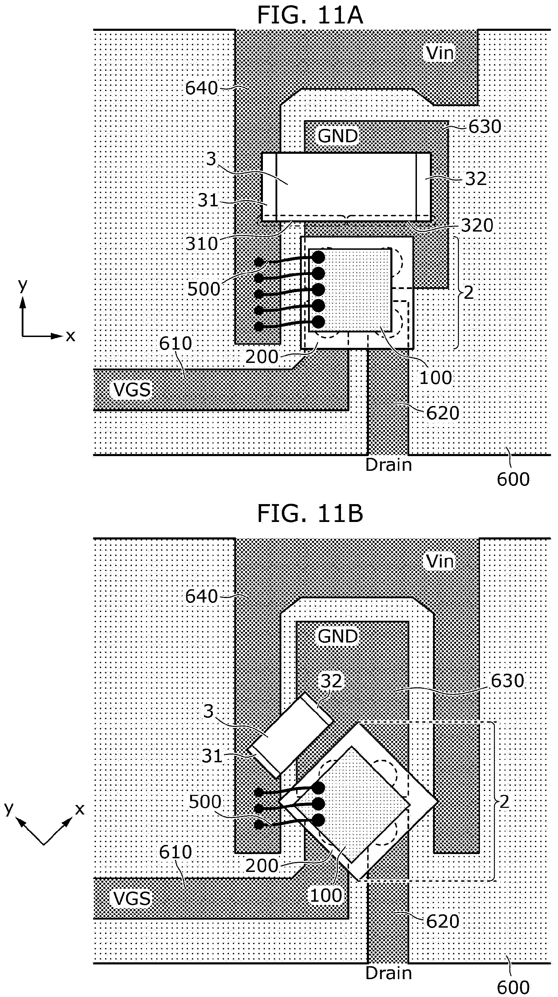

   FIG. 11A is a plan view of an example of the structure of the semiconductor device according to Embodiment 6.
[FIG. 11B]
   FIG. 11B is a plan view of an example of the structure of the semiconductor device according to Embodiment 6.
[FIG. 11C]

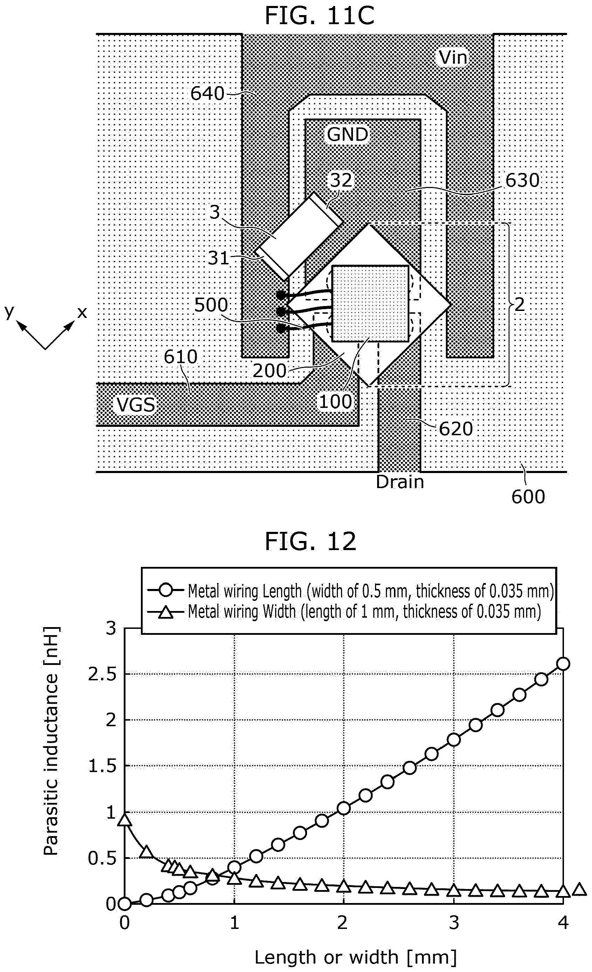

   FIG. 11C is a plan view of an example of the structure of the semiconductor device according to Embodiment 6.
[FIG. 12]
   FIG. 12 is a graph showing a magnitude relation between a length of a copper wiring and a parasitic inductance.
[FIG. 13]

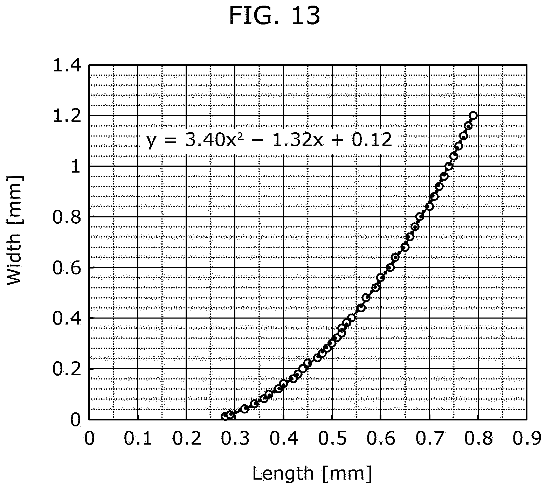

   FIG. 13 is a graph showing a relation between a length and a width with which a copper wiring has a parasitic inductance of 0.35 nH.
[FIG. 14A]

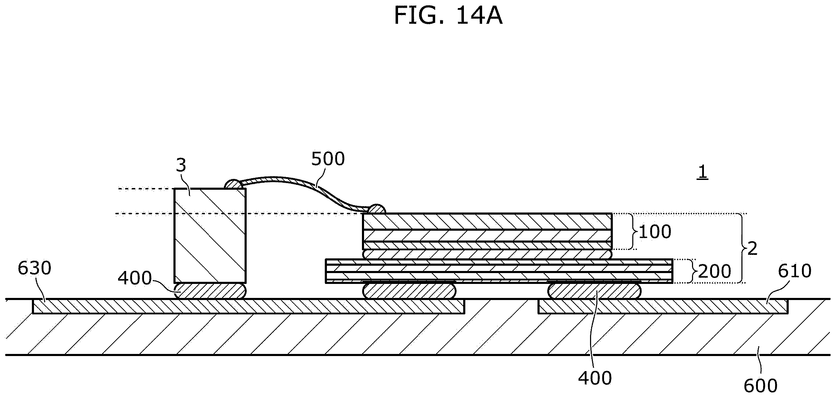

   FIG. 14A is a cross-sectional view of an example of a structure of a semiconductor device according to Embodiment 7.
[FIG. 14B]

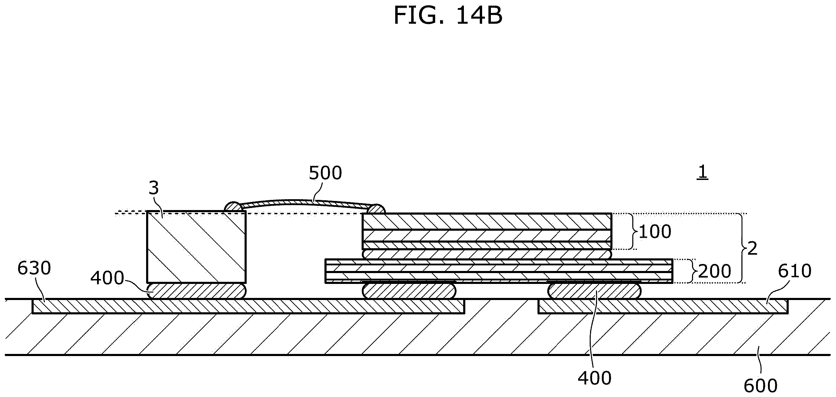

   FIG. 14B is a cross-sectional view of an example of the structure of the semiconductor device according to Embodiment 7.
[FIG. 15A]

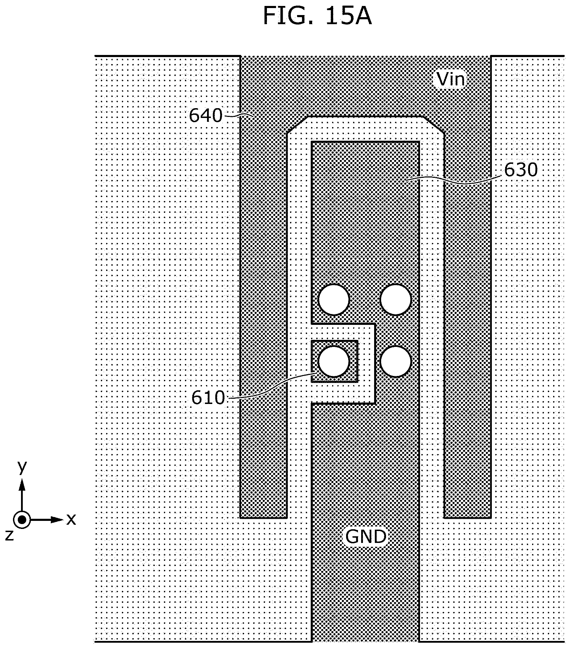

   FIG. 15A is a plan view of an example of a structure of a mounting board before a layered body and a bypass capacitor are arranged in a semiconductor device according to Embodiment 8.
[FIG. 15B]

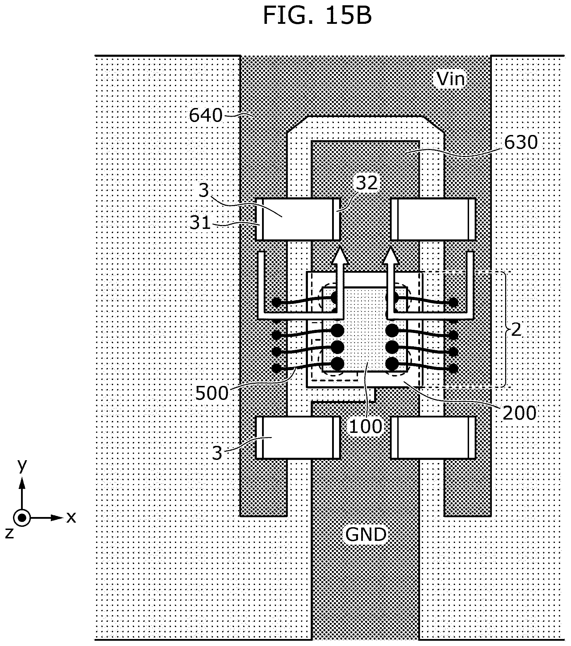

   FIG. 15B is a plan view of an example of a structure of the semiconductor device according to Embodiment 8.
[FIG. 15C]

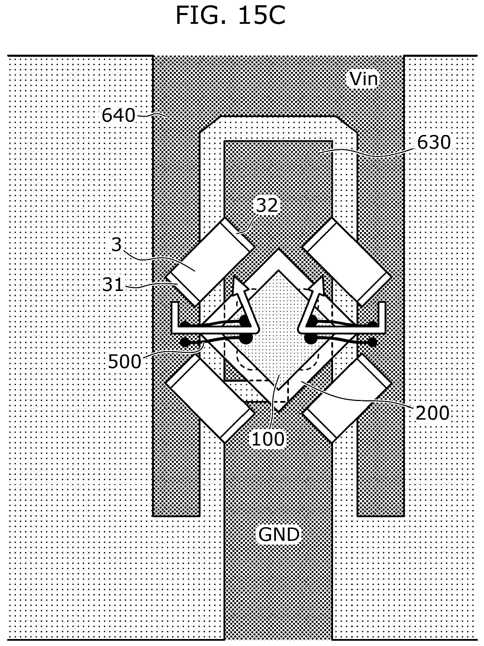

   FIG. 15C is a plan view of an example of the structure of the semiconductor device according to Embodiment 8.
[FIG. 16]

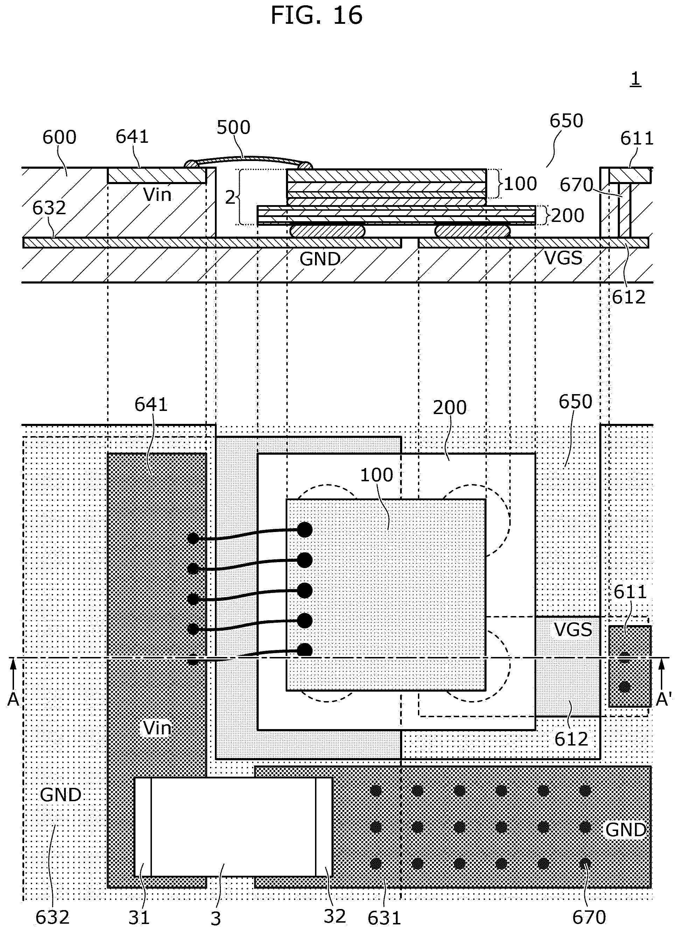

   FIG. 16 is a cross-sectional view and a plan view of an example of a structure of a semiconductor device according to Embodiment 9.
[FIG. 17]

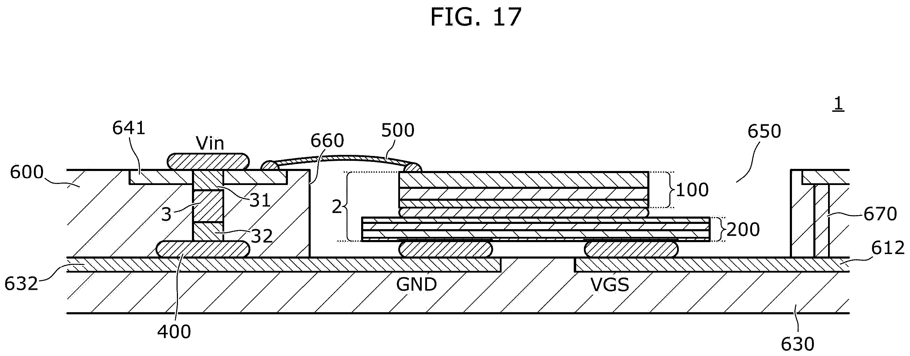

   FIG. 17 is a cross-sectional view of an example of a structure of a semiconductor device according to Embodiment 10.

### [Description of Embodiments]

### [Circumstances leading to one aspect of the present disclosure]

Minimum constituent elements required by a light source module used for distance measurement are a light-emitting element, a switching element that controls current conduction to the light-emitting element, and a power supply that supplies electrical energy to the light-emitting element and the switching element. It is generally well known that a power supply has insufficient responsiveness to pulses in the order of nanoseconds, such as highfrequency waves, due to long wirings from the power supply to elements or the like. A technique for ensuring high responsiveness by using, as a transient electric charge source, a bypass capacitor having favorable frequency characteristics arranged in proximity to a high-speed element is widely used as a conventional technique. In other words, minimum constituent elements required by a light source module are elements each having a different one of three types of functions of a light-emitting element, a switching element, and a bypass capacitor. Elements other than the above three types of the elements may be included depending on uses, conditions, and functions. In particular, a switching element is often embedded as a driver IC (a semiconductor integrated circuit element) including a gate driver circuit, a protective function, or the like, in a light source module. A light source module without the three elements mentioned at the beginning of the paragraph is not practicable.

A circuit is formed by connecting a light-emitting element, a switching element, and a bypass capacitor in series, and this circuit as a whole is referred to as a light source module. The light-emitting element, the switching element, and the bypass capacitor are disposed on a printed circuit board (PCB) or a submount board, and are connected with each other by metal wirings including mainly copper. Although parasitic inductance occurs inside each of the elements, parasitic inductance also occurs in each of the metal wirings (hereinafter may also be referred to simply as wirings). Since parasitic inductance increases with an increase in length of a wiring, there is a demand for a means to shorten a wiring.

A distance measurement technique using a ToF method is characterized by measuring a distance to a distant object by irradiating the object with light and measuring time taken by the light to be reflected from the object. FIG. 1A schematically illustrates an outline of the ToF method. Distance (m) is calculated by speed of light (m/s) × t_{tof} (s) / 2. In order to improve distance measurement accuracy, it is required to perform pulse conduction to a light-emitting element at high frequencies and to cause each waveform of pulsed light to be a square shape with a steep rise. However, since the influence of parasitic inductance serves as a block to achieving an ideal square shape, an error occurs in time measurement as shown in FIG. 1B, which makes it difficult to improve distance measurement accuracy.

In view of the above, the inventors examined structures, combinational configurations, and arrangements of elements having three types of functions of a light-emitting element, a switching element, and a bypass capacitor, and found out necessary conditions for reducing parasitic inductance. As a result, the inventors came up with the following semiconductor device (light source module).

A semiconductor device of a hybrid type according to one aspect of the present disclosure includes: a light-emitting element; a semiconductor integrated circuit element including a switching element that is connected in series with the light-emitting element and controls current conduction to the light-emitting element in response to a control signal externally inputted; and a bypass capacitor that supplies electric charges to the light-emitting element and the semiconductor integrated circuit element. The light-emitting element, the semiconductor integrated circuit element, and the bypass capacitor form a power loop. The light-emitting element and the switching element constitute a layered body in which respective principal surfaces of the light-emitting element and the switching element are layered in parallel and face-to-face. The layered body is mounted on a mounting board. When, of the light-emitting element and the switching element constituting the layered body, one element mounted on the mounting board is a lower element, and an other element mounted on the lower element is an upper element, the bypass capacitor includes one electrode connected to the lower element and an other electrode connected to the upper element. In a plan view of the semiconductor device, when a direction from the one electrode to the other electrode inside the bypass capacitor is a first direction, the bypass capacitor is arranged so that a side of the bypass capacitor parallel to the first direction includes a portion that is parallel to and faces one peripheral side of the layered body.

Since the above-described semiconductor device includes the elements required for a light source module and necessary to reduce parasitic inductance, the semiconductor device makes it possible to obtain pulsed light having a waveform more similar to a square shape, and to significantly increase distance measurement accuracy.

A semiconductor device of a hybrid type may include: a light-emitting element; and a discrete switching element that is connected in series with the light-emitting element and has a switching function of controlling current conduction to the light-emitting element in response to a control signal externally inputted. The light-emitting element and the discrete switching element may constitute a layered body in which respective principal surfaces of the light-emitting element and the discrete switching element are layered in parallel and face-to-face.

Since the above-described semiconductor device is capable of reducing parasitic inductance occurring in the connection between the light-emitting and the switching element, the semiconductor device makes it possible to obtain pulsed light having a waveform more similar to a square shape required for a light source module, and to significantly increase distance measurement accuracy.

Hereinafter, specific examples of the semiconductor device according to one aspect of the present disclosure will be described with reference to the drawings. Each of the embodiments described below shows one specific example of the present disclosure. Therefore, numerical values, shapes, constituent elements, and the arrangement and connection of the constituent elements shown in the following embodiments are mere examples, and are not intended to limit the scope of the present disclosure. Moreover, the respective figures are schematic diagrams and are not necessarily precise illustrations. In the respective figures, the same reference sign is assigned to substantially identical constituent elements, and overlapping description is omitted or simplified.

### [Embodiment 1]

Hereinafter, a configuration and a structure of semiconductor device (light source module) 1 according to Embodiment 1 will be described. FIG. 2A schematically illustrates a cross section of semiconductor device 1 according to Embodiment 1.

Light-emitting element 100 in Embodiment 1 is a vertical cavity surface emitting laser (VCSEL) mainly including a compound semiconductor such as GaAs. A VCSEL has quantum well structure 111 and a cavity structure and emits light having a predetermined wavelength through one principal surface 101 or other principal surface 102 facing away from one principal surface 101 as a light-emitting surface. In Embodiment 1, light-emitting element 100 is layered on switching element 200, and other principal surface 102 is exposed as a light-emitting surface to an upper side that is the outside. In other words, one principal surface 101 of light-emitting element 100 is parallel to and face-to-face with other principal surface 202 of switching element 200, and is in direct or indirect contact and connected in series with switching element 200.

Switching element 200 in Embodiment 1 is mounted on a PCB or submount board 600 (hereinafter may be commonly referred to as a mounting board). The mounting is performed by providing solder joint component 400 to an electrode pad portion of switching element 200. Switching element 200 has a function of controlling current conduction to light-emitting element 100. To put it another way, switching element 200 controls light emission from light-emitting element 100.

In Embodiment 1, switching element 200 is a discrete semiconductor element that is of a chip size package (CSP) type enabling facedown mounting and includes a metal-oxide semiconductor field-effect transistor (MOSFET). The term discrete means a semiconductor element having a single function for a single purpose. Generally speaking, in addition to a MOSFET structure, elements having other functions such as a Zener diode for electrostatic discharge (ESD) protection etc. for a gate terminal are disposed in the same chip in a MOSFET. However, these elements are used solely to achieve stable functions just as a MOSFET. A MOSFET including those elements is defined as a discrete MOSFET. On the other hand, a semiconductor element including multiple functions and elements for multiple purposes (e.g., a gate driver circuit, an over temperature protective function, and an overcurrent protective function in addition to functions of a MOSFET) is defined as an integrated circuit element.

Switching element 200 mainly includes a single crystal semiconductor such as Si or a compound semiconductor such as GaN. Moreover, the MOSFET that is switching element 200 in Embodiment 1 is a vertical type trench MOSFET having a vertical channel. FIG. 2C schematically illustrates a structure of switching element 200. Switching element 200 includes source region 215, a source electrode (part of 212), and source electrode pad 250 on one principal surface 201 side, and gate electrode 216 and gate electrode pad 260 on one principal surface 201. Switching element 200 further includes a drain region on other principal surface 202 side facing away from the one principal surface 201 side. Drain electrode 220 is exposed to the other principal surface 202 side. In the MOSFET having the structure shown in FIG. 2C, although the drain region includes semiconductor substrate 210 and low concentration impurity layer 211, semiconductor substrate 210 may be hereinafter referred to as drain region 210 for the sake of convenience.

Light-emitting element 100 is layered on switching element 200 in contact with drain electrode 220. In other words, light-emitting element 100 is mounted on mounting board 600 via switching element 200. A gate of switching element 200 controls current flowing from drain region 210 to source region 215 in switching element 200. When the gate of switching element 200 is turned on in response to an external signal, current flows into light-emitting element 100, and light-emitting element 100 emits light; and when the gate of switching element 200 is turned off in response to an external signal, current stops flowing into light-emitting element 100, and light-emitting element 100 stops emitting light. FIG. 2B is a schematic plan view of a layered structure in which light-emitting element 100 and switching element 200 are layered. A dashed perfect circle indicates a projected position of an electrode pad provided on one principal surface 201 of switching element 200.

In Embodiment 1, only the layered structure (hereinafter referred to as a layered body) of light-emitting element 100 and switching element 200 is referred to as light source module 1. How current flows in light source module 1 is as follows. At the moment when the gate of switching element 200 is turned on, current from a power supply cathode not shown reaches wire bond 501 provided on other principal surface 102 of light-emitting element 100 via a wiring (Vin wiring 640) and wiring 500, and flows from other principal surface 102 side to one principal surface 101 side inside light-emitting element 100 in a substantially vertical direction. At this time, while the current conduction continues, in light-emitting element 100, light continues to be generated in quantum well structure 111, excited via the cavity structure, and emitted from other principal surface 102 that is a light-emitting surface.

Light-emitting element 100 and switching element 200 are connected in series. Current passing through light-emitting element 100 flows from drain electrode 220 of switching element 200 to a wiring (GND wiring 630) provided to mounting board 600 via drain region 210 and the channel and further via source region 215, the source electrode (part of 212), source electrode pad 250, and solder joint component 400, and returns to a power supply anode (to be exact, a power supply ground) via the wiring. This state continues while the gate of switching element 200 is left on.

In semiconductor device (light source module) 1 in Embodiment 1, parasitic inductance occurs inside light-emitting element 100, a connection portion between light-emitting element 100 and switching element 200, inside switching element 200, a connection portion between switching element 200 and mounting board 600, wiring 500 connecting the power supply and light-emitting element 100, and the wirings included in mounting board 600. If there is a conduction path through which current flows, parasitic inductance occurs in the conduction path. Inductance that inevitably occurs in a manner unintended by circuit design is referred to as parasitic inductance. Parasitic inductance has a significant influence on light-emitting responsiveness of semiconductor device (light source module) 1, and it is imperative for light source module 1 to reduce parasitic inductance to improve distance measurement accuracy.

To reduce parasitic inductance, a physical path through which current passes can be shortened in semiconductor device (light source module) 1 as a whole. In semiconductor device (light source module) 1 in Embodiment 1, since light-emitting element 100 and switching element 200 constitute layered body 2, and switching element 200 is the vertical type trench MOSFET, a conduction path is a substantially linear, shortest path from the other principal surface 102 side, which is the light-emitting surface of light-emitting element 100, to mounting board 600 of switching element 200. Accordingly, parasitic inductance between light-emitting element 100 and switching element 200 is most reduced in principle.

FIG. 3 schematically illustrates a conventional lateral configuration as Comparative Example 1. Conventionally, as shown in FIG. 3, light-emitting element 100 and switching element 200 are not layered unlike Embodiment 1, and light-emitting element 100 and switching element 200 are separately mounted on mounting board 600 and connected by a wiring (not shown in FIG. 3). Light-emitting element 100 and switching element 200 need be connected by a wiring even when light-emitting element 100 and switching element 200 are disposed close to each other, and parasitic inductance occurs as much as the length of the wiring. Moreover, light-emitting element 100 as a common marketed product is often commercially available as a package mounted on a submount board, and using such a package makes a wiring from light-emitting element 100 to a package external form excessively longer. On the other hand, in Embodiment 1, since light-emitting element 100 and switching element 200 are layered, a connection distance is shortest. Additionally, since a conduction path inside light-emitting element 100 and switching element 200 has a length equal to a thickness of each of light-emitting element 100 and switching element 200, it is clear that the conduction path is a shortest path resulting from completely eliminating an excess conduction path.

FIG. 4 shows an emission waveform of light from light-emitting element 100 when pulsed conduction is performed on switching element 200 in the arrangement described in Embodiment 1 ((a) in FIG. 4), and an emission waveform of light from light-emitting element 100 when pulsed conduction is performed on switching element 200 in the arrangement described in Comparative Example 1 ((b) in FIG. 4). (c) in FIG. 4 will be described later. In FIG. 4, the vertical axis represents emission intensity (W), and the horizontal axis represents time (ns). Time = 0 ns is based on a moment when the gate of switching element 200 is turned on.

A comparison between (a) and (b) in FIG. 4 clearly shows that although light emission starts at a moment when the gate of switching element 200 is turned on, rising is faster in (a) than (b) in FIG. 4. In (b) in FIG. 4, as stated above, since the long wiring between the package external form of light-emitting element 100 and switching element 200 causes the parasitic inductance of the wiring to be large as approximately 2.0 nH, rising is slow and a peak height is low due to a transition to an off operation before the waveform fully rises. On the other hand, in (a) in FIG. 4, since light-emitting element 100 and switching element 200 are layered to allow a distance between light-emitting element 100 and switching element 200 to be shortest in Embodiment 1, it is possible to produce an effect of reducing parasitic inductance due to a wiring. Moreover, since that switching element 200 is a vertical type trench MOSFET passing current in a vertical direction allows a conduction path inside switching element 200 to be shortest, it is possible to produce an effect of reduce parasitic inductance inside switching element 200. As a result of these effects, it is possible to reduce the parasitic inductance to 1.0 nH and significantly improve rising as shown in (a) in FIG. 4. A square waveform with a steeper rise leads to greater improvement of distance measurement accuracy of semiconductor device (light source module) 1. Furthermore, steep rising also leads to improvement of an output peak (a waveform height), and it is possible to expect an effect of improving distance measurement accuracy or an effect of increasing a sensing distance due to a higher peak.

Although Embodiment 1 states that switching element 200 is the vertical type trench MOSFET, it is possible to produce the effects of the present disclosure even when switching element 200 is a lateral type MOSFET. Examples of a lateral type MOSFET include a planar transistor and a laterally diffused metal-oxide field-effect transistor (LDMOS). A drain extraction region connected to drain region 210 may be provided on the one principal surface 201 side of switching element 200, and gate electrode 216 via insulating film 217 may be provided as a lateral channel between the drain extraction region and source region 215 provided on the one principal surface 201 side. Such a structure makes it possible to use a lateral type MOSFET as switching element 200 while drain electrode 220 covers the other principal surface 202 side of switching element 200. Although the effect of reducing parasitic inductance inside switching element 200 is reduced by an amount of the lateral channel when the lateral type MOSFET is used as switching element 200, compared to when the vertical type trench MOSFET is used as switching element 200, it is possible to reduce capacitance (charge amount Qg) associated with the gate structure, which is meaningful to an increase in responsiveness.

Semiconductor device (light source module) 1 includes layered body 2 composed of switching element 200 as a lower element mounted on mounting board 600 and light-emitting element 100 as an upper element mounted on top of switching element 200, which is the lower element. Layered body 2, however, may be composed of light-emitting element 100 as a lower element and switching element 200 as an upper element. Since no wirings are necessary to connect light-emitting element 100 and switching element 200 constituting layered body 2 in semiconductor device (light source module) 1 regardless of whether light-emitting element 100 is one of a lower element and an upper element and switching element 200 is the other of the lower element and the upper element, the effectiveness in reducing parasitic inductance remains the same.

In Embodiment 1, although light-emitting element 100 emits light mostly through a light-emitting surface that is other principal surface 102, a portion of light leaks through a surface (one principal surface 101 or a side surface) that is not the light-emitting surface. In order to increase luminous efficiency of semiconductor device (light source module) 1, it is desirable to collect and make effective use of light leaking through surfaces that are not the light-emitting surface. For this purpose, in a plan view of semiconductor device (light source module) 1, when semiconductor device (light source module) 1 includes a reflector for at least a region immediately below light-emitting element 100 or, desirably, a region having an area greater than an area of light-emitting element 100 so that the region contains light-emitting element 100 in the plan view, semiconductor device (light source module) 1 makes it possible to reflect the light leaking through the surfaces, which are not the light-emitting surface, to a light-emitting surface side. Accordingly, it is desirable to ensure a certain region covered by drain electrode 220 in other principal surface 202 of switching element 200, to cause the region covered by drain electrode 220 to have an area greater than or equal to the area of light-emitting element 100, and to mount light-emitting element 100 on the region. Since it is possible to expose drain electrode 220 to the other principal surface 202 side when switching element 200 originally includes drain region 210 in other principal surface 202, it is easy to achieve the above-described structure.

Such a structure makes it possible to efficiently reflect the light leaking through the surfaces, which are not the light-emitting surface of light-emitting element 100, to the light-emitting surface side, and allows semiconductor device (light source module) 1 to have a satisfactory luminous efficiency. Moreover, when drain electrode 220 of switching element 200 includes even a portion of a metal layer including silver (Ag) or copper (Cu) having a high reflectance, the above effect is further enhanced. Furthermore, drain electrode 220 of switching element 200 may be disposed entirely on other principal surface 202 of switching element 200. Such a configuration makes it possible to extensively reflect the light leaking through the surfaces, which are not the light-emitting surface of light-emitting element 100, to the light-emitting surface side, and allows semiconductor device (light source module) 1 to have a satisfactory luminous efficiency.

In semiconductor device (light source module) 1 according to Embodiment 1, light-emitting element 100 and switching element 200 are independent elements functioning separately, and are combined in a hybrid manner and layered. To put it another way, light-emitting element 100 and switching element 200 need be connected in series in one way or another.

A desirable connection method is metal joining. A joining process is performed by joining the one principal surface 101 side of light-emitting element 100 and the other principal surface 202 side of switching element 200 in parallel and face-to-face and brining electrode metals included in the respective surfaces into contact with each other. There are various methods for a joining process. For example, ultrasonic waves are used, or pressure application, heat treatment, or a combination of these is performed. It is required to properly select an electrode metal included in one principal surface 101 of light-emitting element 100, and a metal included in drain electrode 220 of switching element 200, in conformity with a joining method among those. Since, in the case of metal joining, a conduction path having an excessive length is not made when light-emitting element 100 and switching element 200 are connected, compared to when an indirect material is additionally used, the metal joining is most desirable from the viewpoint of reduction of parasitic inductance.

When light-emitting element 100 and switching element 200 are connected by a method different from the metal joining, it is desirable to bond light-emitting element 100 and switching element 200 using a conductive adhesive component. FIG. 2A schematically illustrates a structure in which light-emitting element 100 and switching element 200 are connected with adhesive component 300. Examples of conductive adhesive component 300 includes Ag paste or sintered silver.

When conductive adhesive component 300 is used, it is desirable that adhesive component 300 fill in gaps between light-emitting element 100 and switching element 200. When a gap is unintentionally created or a region not filled in with adhesive component 300 grows large, the adhesiveness between light-emitting element 100 and switching element 200 is weak, and semiconductor device 1 has an insufficient strength, which are likely to lead to a decrease in reliability. For this reason, when adhesive component 300 is used, in a plan view of semiconductor device 1, it is desirable to cause an area of a portion in which adhesive component 300 is disposed to be slightly larger than an area of a region in which light-emitting element 100 and switching element 200 overlap each other. At this time, in at least one peripheral side among four peripheral sides of light-emitting element 100 in the plan view, adhesive component 300 extends outward. When such an extending portion is present, the adhesiveness between light-emitting element 100 and switching element 200 is strong, which means it is not likely to lead to a decrease in reliability.

However, since adhesive component 300 need be conductive, placing an excessive amount of adhesive component 300 results in protrusion of adhesive component 300 from switching element 200 that is a lower element, which may unintentionally cause semiconductor device 1 to be short-circuited. For this reason, by disposing a projecting structure projecting from a lower part to an upper part of layered body 2 in the periphery of other principal surface 202 in which drain electrode 220 of switching element 200, the lower element, is disposed, it is effective to provide a barrier function to the periphery so that adhesive component 300 does not overflow from switching element 200. The above projecting structure is effective even if the projecting structure is disposed along at least one peripheral side among the four peripheral sides of other principal surface 202 on which drain electrode 220 of switching element 200 is disposed.

FIG. 5 shows an example of a projecting structure. A projecting structure is sufficient to prevent the overflow of adhesive component 300. As shown in FIG. 5, the projecting structure may include only a metal included in drain electrode 220 or have a structure obtained by combining semiconductor substrate 210 and drain electrode 220. It is desirable that a height of the projecting structure do not exceed a height (thickness) of light-emitting element 100. This is because the possibility that wiring 500 connecting Vin wiring 640 and the light-emitting surface of light-emitting element 100 makes contact with the projecting structure is reduced when the height of the projecting structure is less than or equal to the height of light-emitting element 100.

Conductive adhesive component 300 may be selectively disposed only in a predefined region. In this case, it is possible to expect an effect of decreasing stress created by layering and mounting light-emitting element 100 and switching element 200. Moreover, when a space between light-emitting element 100 and switching element 200 is being sealed with a sealer such as resin, a certain amount of a space between light-emitting element 100 and switching element 200 produces an effect of facilitating even entry and filling of the sealer.

In a step of forming layered body 2 including light-emitting element 100 and switching element 200 in Embodiment 1, light-emitting element 100 and switching element 200 are mounted by a procedure. There are method (A) in which light-emitting element 100 and switching element 200 are configured as layered body 2, and then layered body 2 is mounted on mounting board 600, and method (B) in which one of light-emitting element 100 and switching element 200 is mounted as a lower element on mounting board 600, and the other of light-emitting element 100 and switching element 200 is mounted as an upper element on a top surface of the lower element.

In consideration of flow of current in layered body 2, it is desirable that a conduction cross-sectional area increase from the upper element toward the lower element. This is because when current flows from the upper element to the lower element, a portion at which the conduction cross-sectional area decreases contributes to an increase in resistance, which makes it harder to handle large current conduction, and semiconductor device 1 itself increases in temperature due to narrowing of a heat dissipation path. Accordingly, it is desirable to adjust the area of the lower element and the upper element or a region through which current flows so that a current density of the lower element is lower than a current density of the upper element when current is passed through layered body 2. In order to achieve these, it is desirable that the lower element have the area larger than the area of the upper element.

The above relation is also effective from the viewpoint of ease of mounting. This is because both methods (A) and (B) include a step of layering the upper element on the top surface of the lower element. Suppose the upper element has a larger area than the lower element does, the lower element cannot be recognized visually at the stage of layering, and mounting is likely to be difficult especially in terms of alignment. Moreover, with regard to ease of forming layered body 2, that is, ease of mounting, it is desirable that both light-emitting element 100 and switching element 200 be rectangular in shape. This is because when both light-emitting element 100 and switching element 200 are rectangular in shape in a plan view, it is easy to bring into alignment and arrange in parallel the four peripheral sides of the upper element and the four peripheral sides of the lower element at the time of forming layered body 2. At this time, even if a problem occurs in which the upper element is rotatively layered on the lower element at the time of forming layered body 2, when a length of a diagonal of the upper element is less than a length of a shorter side of the lower element in the plan view, it is possible to reduce a possibility of forming layered body 2 in which the upper element overhangs the lower element. It should be noted that a periphery of layered body 2 in the plan view means a periphery of an outermost element among the upper element and the lower element at respective positions, regardless of the area of the upper element and the lower element or an arrangement relation between the upper element and the lower element.

When both light-emitting element 100 and switching element 200 are rectangular in shape, it is desirable that the four peripheral sides of the upper element be parallel to the corresponding four peripheral sides of the lower element in a plan view, and it is further desirable that layered body 2 be formed based on an arrangement that the positions of the centers of the upper element and the lower element are the same. At this time, it is possible to symmetrically disperse external force applied to layered body 2 or stress occurring in layered body 2 at the time of forming layered body 2 over entire layered body 2. Since it is easy to suppress the occurrence of a portion in which external force or stress locally concentrates, it is possible to reduce a possibility that layered body 2 is physically broken down.

When both light-emitting element 100 and switching element 200 are rectangular in shape, it is desirable that the four peripheral sides of the upper element be parallel to the corresponding four peripheral sides of the lower element in a plan view, and at least one peripheral side among the four peripheral sides of an element may overlap the corresponding peripheral side among the four peripheral sides of an other element in the plan view, or the four peripheral sides of the element may be located closer to one of the four peripheral sides of the other element with respect to the center. At this time, in the plan view, it is possible to ensure an exposure area large to some extent in a portion of the top surface of the lower element not covered by the upper element. An electrode pad of the lower element or a visible mark for identifying layered body 2 or the lower element may be disposed in this portion. Such a mark is convenient because the mark can identify the lower element even after layered body 2 is formed.

When both light-emitting element 100 and switching element 200 are rectangular in shape, the four peripheral sides of the upper element need not be parallel to the corresponding four peripheral sides of the lower element in a plan view. Here, when wire bonding is performed on the upper element of layered body 2, it is possible to shorten wiring 500 as much as possible, based on a positional relation with the wirings included in mounting board 600.

Moreover, some alignment mark indicating a position at which the upper element is mounted may be disposed on the top surface of the lower element. This produces an effect of facilitating alignment when layered body 2 is formed in any one of above-described methods (A) and (B).

### [Embodiment 2]

Hereinafter, a configuration and a structure of semiconductor device (light source module) 1 according to Embodiment 2 will be described. FIG. 6 schematically illustrates a cross section of semiconductor device 1 according to Embodiment 2.

Embodiment 2 differs from Embodiment 1 in that switching element 200 is a lateral type MOSFET having a lateral channel. Switching element 200 includes drain electrode 220 and drain region 210, and further includes, on the one principal surface 201 side, drain extraction region 213 electrically connected to drain region 210. Well layer 214 and source region 215 are disposed on the one principal surface 201 side, and a space between source region 215 and drain extraction region 213 is equivalent to a lateral channel. Gate electrode 216 is in contact with a portion of well layer 214 and a portion of low concentration impurity layer 211 via insulating film 217. When a voltage applied to gate electrode 216 in response to an external signal exceeds a threshold value, a lateral channel is formed in well layer 214 in contact with gate electrode 216, and current flows as a result.

How current flows in semiconductor device (light source module) 1 in Embodiment 2 is as follows. At the moment when the gate of switching element 200 is turned on, current from a power supply cathode not shown reaches wire bond 501 provided on other principal surface 102 of light-emitting element 100 via a wiring (Vin wiring 640) and wiring 500, and flows from the other principal surface 102 side to the one principal surface 101 side inside light-emitting element 100 in a substantially vertical direction. At this time, in light-emitting element 100, while the current conduction continues, light continues to be generated in quantum well structure 111, excited via the cavity structure, and emitted from other principal surface 102 that is a light-emitting surface.

Light-emitting element 100 and switching element 200 are connected in series. Current passing through light-emitting element 100 flows from drain electrode 220 of switching element 200 to a wiring (GND wiring 630) provided to mounting board 600 via drain region 210, drain extraction region 213, and the lateral channel and further via source region 215, the source electrode (part of 212), source electrode pad 250, and solder joint component 400 in stated order, and returns to a power supply anode (to be exact, a power supply ground) via the wiring. This state continues while the gate of switching element 200 remains on.

A conduction path inside switching element 200 becomes slightly longer when the lateral type MOSFET is used as switching element 200 as described in Embodiment 2 than when the vertical type trench MOSFET is used as switching element 200 as described in Embodiment 1. For this reason, although the effect of reducing parasitic inductance in switching element 200 is reduced by the length, it is well known that, compared to the vertical type trench MOSFET, the lateral type MOSFET has a small capacitance (charge amount Qg) associated with the gate structure, and it is possible to make a switching speed of the lateral type MOSFET higher than a switching speed of the vertical type trench MOSFET, which is meaningful to an increase in responsiveness as a result.

Since switching element 200 described in Embodiment 2 includes drain extraction region 213 on the one principal surface 201 side, switching element 200 can also include a drain electrode and drain electrode pad 270 on the one principal surface 201 side. Drain electrode pad 270 is not essential to semiconductor device (light source module) 1 in the present disclosure, so drain electrode pad 270 need not be connected to a wiring via solder joint component 400. Nevertheless, when drain electrode pad 270 is also disposed on the one principal surface 201 side and is further connected to, for example, a wiring for testing a semiconductor device, it is possible to meaningfully use drain electrode pad 270 for some purpose such as evaluating the functioning of the semiconductor device during manufacturing.

### [Embodiment 3]

Hereinafter, a configuration and a structure of semiconductor device (light source module) 1 according to Embodiment 3 will be described. FIG. 7 schematically illustrates a cross section of semiconductor device 1 according to Embodiment 3.

Embodiment 3 differs from Embodiment 1 in that switching element 200 is a lateral type MOSFET having a lateral channel. Moreover, mounting board 600 has a step, light-emitting element 100 is disposed on a lower stage side of the step, switching element 200 is disposed on an upper stage side of the step, and light-emitting element 100 and switching element 200 are only partially layered in a plan view. In Embodiment 3, a portion in which light-emitting element 100 and switching element 200 are layered in the plan view is referred to as a layered body. Layered body 2 in Embodiment 3 is a portion indicated by a dashed line in FIG. 7.

How current flows in semiconductor device (light source module) 1 in Embodiment 3 is as follows. At the moment when the gate of switching element 200 is turned on, current flows from a power supply cathode not shown to one principal surface 101 of light-emitting element 100 via Vin wiring 640 provided to mounting board 600, and further flows toward the other principal surface 102 side of light-emitting element 100 inside light-emitting element 100 in a substantially vertical direction. At this time, in light-emitting element 100, while the current conduction continues, light continues to be generated in quantum well structure 111, excited via the cavity structure, and emitted from other principal surface 102 that is a light-emitting surface.

Light-emitting element 100 and switching element 200 are connected in series in the portion in which light-emitting element 100 and switching element 200 are layered. Current passing through light-emitting element 100 flows from drain electrode 220 of switching element 200 to a wiring (GND wiring 630) provided to mounting board 600 via high concentration impurity region 218 and the lateral channel and further via source region 215, the source electrode (part of 212), source electrode pad 250, and solder joint component 400 in stated order, and returns to a power supply anode via the wiring. This state continues while the gate of switching element 200 is left on.

In Embodiment 3, light-emitting element 100 and switching element 200 are only partially layered, and the conduction path includes no redundant wirings. Consequently, it is possible to produce an effect of reducing parasitic inductance regarding the connection portion. Moreover, compared to Embodiments 1 and 2, since it is possible to dispose light-emitting element 100 without switching element 200 blocking most of the area of light-emitting element 100, both one principal surface 101 and other principal surface 102 can be designed to emit light. However, in order to emit light from the one principal surface 101 side of light-emitting element 100 to a rear surface side of mounting board 600, an opening need be provided to only a portion of mounting board 600 immediately below light-emitting element 100. In addition, that Embodiment 3 eliminates the need for wirings is significant in reducing parasitic inductance or avoiding a failure caused by parts.

Switching element 200 in Embodiment 3 includes drain electrode 220 on the one principal surface 201 side, and further need include drain electrode pad 270. On the other hand, switching element 200 need not include drain electrode 220 on the other principal surface 202 side. Moreover, unlike Embodiment 2, switching element 200 need not include, on the one principal surface 201 side, drain extraction region 213 electrically connected to drain region 210. As with Embodiment 2, well layer 214 and source region 215 are disposed on the one principal surface 201 side. A space between source region 215 and high concentration impurity region 218 is equivalent to a lateral channel. Gate electrode 216 is in contact with a portion of well layer 214 via insulating film 217. When a voltage applied to gate electrode 216 in response to an external signal exceeds a threshold value, a lateral channel is formed in well layer 214 in contact with gate electrode 216, and current flows as a result.

In Embodiment 3, mounting board 600 has the step, and light-emitting element 100 and switching element 200 are disposed on the lower stage side and the upper stage side of the step, respectively, so that light-emitting element 100 and switching element 200 are partially layered. However, it is not necessary to dispose light-emitting element 100 and switching element 200 on the lower stage side and the upper stage side, respectively, as shown in FIG. 7. Light-emitting element 100 and switching element 200 may be disposed on the upper stage side and the lower stage side, respectively. However, it is desirable that a height of the step of mounting board 600 be approximately the same as a height (thickness) of one of light-emitting element 100 and switching element 200 that is disposed on the lower stage side so that it is easy to partially layer light-emitting element 100 and switching element 200. It is further desirable that, as shown in FIG. 7, the other principal surface of the lower element disposed on the lower stage side be flush with the upper stage side of mounting board 600.

### [Embodiment 4]

Switching element 200 described in each of Embodiments 1 to 3 is a discrete MOSFET that forms layered body 2 with light-emitting element 100. Embodiment 1 has shown the vertical type trench MOSFET, and Embodiments 2 and 3 have shown the lateral type MOSFET.

FIG. 8A is a schematic diagram illustrating the discrete MOSFET, which is switching element 200, when seen in a plan view from the one principal surface 201 side. The MOSFET includes effective region 255 including the channel, and source electrode pad 250 that is equivalent to an exposed portion of the source electrode. In Embodiment 4, effective region 255 accounts for approximately half the MOSFET, and two of four perfectly circular electrode pads are source electrode pads 250, though the present disclosure is not limited to this. Control region 265 including one gate electrode pad 260 and drain extraction region 275 including one drain electrode pad 270 are disposed in a portion other than effective region 255. A peripheral portion of the MOSFET includes non-functional region 280 that is equivalent to none of effective region 255, control region 265, and drain extraction region 275. Although FIG. 8A shows the shape of the electrode pads in a perfectly circular form, the present disclosure is not limited to this. The shape may be oval or rounded rectangular. End portions of the electrode pads may be not only circular in shape but also rectangular in shape or polygonal in shape. Additionally, all the electrode pads may have or need not have the same shape.

Referring back to the distance measurement function of semiconductor device (light source module) 1, responsiveness to light emitted from light-emitting element 100 is essential. When switching element 200 is the MOSFET, expanding effective region 255 including the channel is effective in making it easy to pass large current by effective region 255 being low-resistance, but on the other hand, expanding effective region 255 leads to an increase in gate capacitance (charge amount Qg) associated with the gate structure as a by-product. Although the above-described parasitic inductance dominates the responsiveness of switching element 200, the gate capacitance has an influence in the MOSFET. In other words, gate drive reduces on-off responsiveness of switching element (MOSFET) 200 having a large gate capacitance, which leads to a reduction of the responsiveness to the light emitted from light-emitting element 100. Accordingly, it is necessary to select an area of switching element (MOSFET) 200 in consideration of an amount of current, resistance, responsiveness, etc. required for semiconductor device (light source module) 1 and further by taking account of the ease of forming layered body 2 with light-emitting element 100.

As stated above, it is desirable that the area of the lower element be larger than the area of the upper element in any mounting method for semiconductor device (light source module) 1. For this reason, increasing the area of switching element (MOSFET) 200 favorably affects the ease of mounting, but expanding effective region 255 as a result reduces the responsiveness. In view of this, as shown in FIG. 8B, it is beneficial to achieve, by expanding non-functional region 280, the area of switching element (MOSFET) 200 to ensure the ease of forming layered body 2, while maintaining the area of effective region 255 that satisfies the amount of current, the resistance, and the responsiveness required for semiconductor device (light source module) 1, and the area of control region 265 or the area of drain extraction region 275. As shown in FIG. 8B, it is effective to expand non-functional region 280, which is equivalent to none of effective region 255, control region 265, and drain extraction region 275, by evenly extending the four peripheral sides of switching element (MOSFET) 200 in a plan view. With regard to the increase in area, it is desirable that the length of the diagonal of the upper element be made less than the length of the shorter side of the lower element.

It should be noted that although Embodiment 4 has described an example of the MOSFET shown in FIG. 8A, a MOSFET may also be as shown in FIG. 8C. In semiconductor device (light source module) 1 that requires driving at larger current, as shown in FIG. 8C, it is appropriate to use switching element (MOSFET) 200 whose area, that is, effective region 255 is increased. In FIG. 8C, switching element 200 includes perfectly circular electrode pads having the same size, and a portion other than one gate electrode pad 260, control region 265, two drain electrode pads 270, drain extraction region 275, and non-functional region 280 included in the periphery portion is effective region 255. In the example shown in FIG. 8C, effective region 255 includes six source electrode pads 250. When the area of switching element (MOSFET) 200 is increased while keeping effective region 255 intact, it is desirable to expand non-functional region 280.

### [Embodiment 5]

FIG. 9A shows an example of an equivalent circuit regarding semiconductor device (light source module) 1. Embodiments 1 to 3 have each described an example of layered body 2 in which light-emitting element 100 and discrete switching element 200 are layered. Semiconductor device (light source module) 1 according to Embodiment 5 includes not only switching element 200 but also semiconductor integrated circuit element (driver IC) 700 containing a gate driver circuit that drives switching element 200. It should be noted that semiconductor integrated circuit element (driver IC) 700 may include other functional circuits of the gate driver circuit. For example, to obtain additional functions, semiconductor integrated circuit element 700 may include common analog control circuits such as an over temperature protection circuit, an over current detection circuit, and a step-down regulator circuit.

FIG. 9B is a schematic diagram of semiconductor integrated circuit element (driver IC) 700 in a plan view. In semiconductor integrated circuit element (driver IC) 700, switching element 200 and gate driver circuit 710 are monolithically disposed on the same chip, which is a chip size package. In FIG. 9B, gate driver circuit 710 is disposed on the left side of the chip, and switching element 200 is disposed on the right side of the chip. In Embodiment 5, both switching element 200 and gate driver circuit 710 include perfectly circular electrode pads having the same size. Each of the electrode pads may be connected to a different function, or some of the electrode pads may be connected to the same function. Moreover, by making pairs of drain electrode pads and source electrode pads that are connected to switching element 200, switching element 200 may be caused to have a plurality of parallel configurations.

FIG. 9C is a schematic diagram of a cross section structure of semiconductor integrated circuit element (driver IC) 700. Gate driver circuit 710 is formed by creating an excavated structure by, for example, dry etching of low concentration impurity region 211 and performing epitaxial growth or impurity doping after covering the entire surface with insulating film 217. This is because, since a potential of drain region (semiconductor substrate) 210 and low concentration impurity region 211 becomes drain voltage and is not zero voltage, insulation from a substrate side is necessary for stable operation of a control circuit. It should be noted that although switching element 200 is illustrated as a vertical type trench MOSFET in FIG. 9C, switching element 200 may also be a lateral type MOSFET.

It is possible to form layered body 2 with light-emitting element 100 using even semiconductor integrated circuit element (driver IC) 700 as a lower element. At this time, it is desirable that switching element 200 included in semiconductor integrated circuit element (driver IC) 700 be the vertical type trench MOSFET, and layered body 2 be formed so that light-emitting element 100 at least partially overlaps the vertical type trench MOSFET. Here, as with FIG. 2A, since it is possible to make the conduction path inside layered body 2 shortest, it is possible to expect the effect of reducing the parasitic inductance.

Unless otherwise specified as being discrete, a switching element in Embodiments 6 to 10 can be read on the semiconductor integrated circuit element described in Embodiment 5. In addition, the technique described in Embodiment 4 can be applied to the semiconductor integrated circuit element. It is noted that embodiment 6 is an embodiment according to the invention.

### [Embodiment 6]

Hereinafter, a configuration and a structure of semiconductor device (light source module) 1 according to Embodiment 6 will be described. FIG. 10A, FIG. 10B, and FIG. 10C schematically illustrate plan views and a cross section of semiconductor device 1 according to Embodiment 6, respectively.

Semiconductor device 1 in Embodiment 6 includes bypass capacitor 3 in addition to light-emitting element 100 and switching element 200 constituting layered body 2. Bypass capacitor 3 is connected in series with layered body 2 and functions to supply electric charges to layered body 2. For this reason, bypass capacitor 3 is essential to the functioning of semiconductor device (light source module) 1. More specifically, bypass capacitor 3, light-emitting element 100, and switching element 200 form a power loop by connecting one electrode 32 and other electrode 31 of bypass capacitor 3 to the lower element and the upper element of layered body 2, respectively.

A power loop in the present disclosure means a conduction path that unidirectionally passes current from one terminal (other electrode 31 or one electrode 32) to an other terminal (one electrode 32, other electrode 31, or power supply ground) via layered body 2 without being electrically interrupted, the one terminal being equivalent to a cathode of bypass capacitor 3 at time of power supply current conduction, the other terminal being equivalent to an anode of bypass capacitor 3 at time of power supply current conduction. It should be noted that such a conduction path is a conduction path that passes a large current of approximately ampere order necessary to obtain a desired light output of a light-emitting element, compared to a minute current consumed by a control circuit etc. Hereinafter, this conduction path may be referred to as a power loop. It is desirable that bypass capacitor 3 be a layered ceramic capacitor having a small internal parasitic inductance and a satisfactory high responsiveness.

Although the following has not been mentioned since Embodiments 1 to 5 are intended to describe the characteristics of layered body 2, bypass capacitor 3 is originally included in any of the embodiments. Embodiment 6 clearly states that bypass capacitor 3 is included, and describes characteristics of layered body 2 and bypass capacitor 3. It should be noted that layered body 2 in Embodiment 6 includes the lower element that is switching element 200, and the upper element that is light-emitting element 100. Moreover, both light-emitting element 100 and switching element 200 are rectangular in shape. Furthermore, although the lower element is assumed to be discrete switching element 200, the present embodiment is not limited to this. The lower element may be semiconductor integrated circuit element 700 including switching element 200.

In Embodiment 6, layered body 2 and bypass capacitor 3 are mounted on same mounting board 600. FIG. 10A shows an example of mounting board 600 before layered body 2 and bypass capacitor 3 are mounted thereon. Four perfect circles indicate planned arrangement positions of electrode pads when switching element 200 is mounted facedown. Metal wirings 610, 620, 630, and 640 each fulfilling a function are provided to mounting board 600. FIG. 10B shows an example of a situation when layered body 2 and bypass capacitor 3 are mounted. One electrode 32 of bypass capacitor 3 is connected to GND wiring 630, and source electrode pad 250 of switching element 200, which is the lower element of layered body 2, is connected to GND wiring 630. Other electrode 31 of bypass capacitor 3 is connected to Vin wiring 640, and Vin wiring 640 and a top surface of light-emitting element 100, which is the upper element of layered body 2, are connected by wiring 500. Source electrode pad 250 and GND wiring 630 are connected using solder joint component 400. One end of gate wiring 610 is connected to gate electrode pad 260 of switching element 200, which is the lower element of layered body 2, via solder joint component 400. The other end of gate wiring 610 is connected to a gate driver (not shown) that controls ON and OFF of switching element 200. The gate driver provides an ON-OFF signal to switching element 200, causing switching element 200 to have enough source current/sink current capability to operate at high speed in response to an externally inputted signal. Wiring 620 is a drain wiring connected to drain electrode pad 270 of switching element 200 via solder joint component 400. Although switching element 200 in Embodiment 6 includes drain electrode pad 270 on the one principal surface 201 side, drain electrode pad 270 need not be provided. Source electrode pad 250 may be provided instead of drain electrode pad 270, and may be connected to GND wiring 630.

Although the following will be described later, it is desirable to arrange bypass capacitor 3 in a plan view so that when a direction from one electrode 32 to other electrode 31 inside bypass capacitor 3 is a first direction, a side of bypass capacitor 3 parallel to the first direction includes a portion that is parallel to and faces one peripheral side of layered body 2. This arrangement plays a significant role in reducing parasitic inductance. Hereinafter, for the sake of convenience, in a plan view, a direction in which layered body 2 and bypass capacitor 3 are parallel to the first direction is defined as an x direction, and a direction that is orthogonal to the x direction and in which layered body 2 and bypass capacitor 3 are arranged is defined as a y direction. In FIG. 10B, a direction in which Vin wiring 640 and GND wiring 630 are bridged is the x direction, and a direction parallel to Vin wiring 640 and GND wiring 630 is the y direction. It should be noted that a first direction is a direction defined with reference to one bypass capacitor 3 in a plan view, and when plurality of bypass capacitors 3 are included, a first direction is defined for each of plurality of bypass capacitors 3. Moreover, an x direction and a y direction are directions defined based on an arrangement relation between one layered body 2 and one bypass capacitor 3 in a plan view, and when plurality of bypass capacitors 3 are included, an x direction and a y direction are defined for each of plurality of bypass capacitors 3.

How current flows in Embodiment 6 is as follows. When the gate of switching element 200 is turned on in response to a gate drive signal from the gate driver (not shown) to which gate wiring 610 is connected, electric charges are supplied from other electrode 31 (equivalent to a cathode at time of current conduction) of bypass capacitor 3, and current flows as a result. The current further flows from other electrode 31 (equivalent to the cathode at the time of current conduction) of bypass capacitor 3 to Vin wiring 640, wiring 500, and light-emitting element 100, which causes light-emitting element 100 to emit light. Light-emitting element 100 continues to emit light while the current conduction continues, that is, during a period in which the gate of switching element 200 is on. The current further returns from light-emitting element 100 to one electrode 32 (equivalent to an anode at time of current conduction, connected to power supply ground) of bypass capacitor 3 through switching element 200, source electrode pad 250 of switching element 200, and GND wiring 630.

To reduce parasitic inductance, it is required to shorten the above-described power loop as much as possible. The path inside layered body 2 is as described in Embodiments 1 to 3, and a path connecting bypass capacitor 3 and layered body 2 will be described in Embodiment 6.

In Embodiment 6, a typical size is assumed as a small light source module. Although the present disclosure is not limited to this, in FIG. 10B, in a plan view, light-emitting element 100 is 1.0 × 1.0 mm, switching element 200 is a discrete vertical type trench MOSFET that is 1.4 × 1.4 mm, and bypass capacitor 3 is 1.0 × 0.5 mm. It should be noted that switching element 200 includes two perfectly circular source electrode pads 250, one perfectly circular gate electrode pad 260, and one perfectly circular drain electrode pad 270 on the one principal surface 201 side, and that the other principal surface 202 side is entirely covered with drain electrode 220. The characteristics, shape, and size of light-emitting element 100 are selected according to a required light output and required characteristics. Moreover, the characteristics, shape, and size of switching element 200 are selected according to a required amount of current, required responsiveness, ease of layering light-emitting element 100 thereon as a lower element, etc. Furthermore, a desired capacitance value, a desired size, and a desired shape of bypass capacitor 3 are selected according to a required amount of current and required responsiveness. FIG. 10B shows, as a small light source module, a typical element size that satisfies these correlations.

The cross section in FIG. 10C shows relative thicknesses in approximately actual size. In other words, light-emitting element 100 has a thickness of 0.1 mm to 0.2 mm, switching element 200 has a thickness of approximately 0.1 mm, layered body 2 has a thickness of 0.3 mm to 0.4 mm, and bypass capacitor 3 has a height of approximately 0.5 mm.

Since wirings 610, 620, 630, and 640 are disposed at regular intervals to prevent a short circuit, wiring 500 connecting Vin wiring 640 and GND wiring 630 needs to have not only a length equivalent to a height of layered body 2 but also a length equivalent to at least the intervals between the wirings. Since bypass capacitor 3 extends across Vin wiring 640 and GND wiring 630, a side of bypass capacitor 3 parallel to the first direction needs to have a length greater than at least the intervals between Vin wiring 640 and GND wiring 630 in a plan view. Additionally, it is desirable to arrange bypass capacitor 3 so that the side parallel to the first direction is parallel to one peripheral side of layered body 2 in the plan view. This is effective in shortening a portion of the power loop in the y direction, the power loop leading from other electrode 31 (equivalent to the cathode at the time of current conduction) of bypass capacitor 3 to one electrode 32 (equivalent to the anode at the time of current conduction, connected to the power supply ground) of bypass capacitor 3 via layered body 2.

FIG. 10D shows an arrangement obtained by rotating bypass capacitor 3 by 45 degrees relative to layered body 2 in FIG. 10B. A bypass capacitor represented by a dashed line in FIG. 10D indicates a position before rotation in FIG. 10B, and an x direction and a y direction in FIG. 10D are defined based on an arrangement relation between the bypass capacitor represented by the dashed line and layered body 2. Since it is necessary to dispose bypass capacitor 3 and layered body 2 at minimum intervals to prevent a short circuit, when the same intervals as in FIG. 10B are provided, it is possible to reduce a certain distance (-Δy1 in FIG. 10D) of Vin wiring 640 in the y direction between other electrode 31 of bypass capacitor 3 and wiring 500; however, a distance of GND wiring 630 in the y direction between one electrode 32 of bypass capacitor 3 and layered body 2 significantly increases (+Δy2 in FIG. 10D) as compared to FIG. 10B, and a total length of the power loop in the y direction increases as a result (+Δy2-Δy1 > 0). Accordingly, it is desirable to arrange bypass capacitor 3 so that the side parallel to the first direction is parallel to the one peripheral side of layered body 2 in the plan view.

Moreover, it is desirable to arrange bypass capacitor 3 so that the side parallel to the first direction includes a portion facing the one peripheral side of layered body 2 in the plan view. This is equivalent to the presence of portions in each of which layered body 2 and bypass capacitor 3 are in the same cross section as shown in FIG. 10C when the cross section of semiconductor device 1 is viewed in the y direction. It should be noted that FIG. 10C is a cross-sectional view of a portion shown by an alternate long and short dash line in FIG. 10B. The above-described arrangement makes it possible to prevent a portion of the power loop in the x direction from extending unnecessarily, the power loop leading from other electrode 31 (equivalent to the cathode at the time of current conduction) of bypass capacitor 3 to one electrode 32 (equivalent to the anode at the time of current conduction, connected to the power supply ground) of bypass capacitor 3 via layered body 2.

FIG. 10E shows an example in which a side of bypass capacitor 3 parallel to the first direction includes no portions facing the one peripheral side of layered body 2 in a plan view. A bypass capacitor represented by a dashed line in FIG. 10E indicates a position of bypass capacitor 3 shown in FIG. 10B relative to layered body 2. As indicated by a two-directional arrow (+Δx) in FIG. 10E, since a distance between bypass capacitor 3 and layered body 2 in the x direction increases, and it is necessary to extend wiring 500 (+Δx), a total length of the power loop in the x direction increases as a result (+Δx+Δx > 0). For this reason, it is desirable to arrange bypass capacitor 3 so that the side parallel to the first direction includes a portion facing the one peripheral side of layered body 2 in the plan view.

When the side of bypass capacitor 3 parallel to the first direction is greater than any peripheral side of layered body 2 in the plan view as shown in FIG. 11A, it is physically difficult to make an arrangement as shown in FIG. 10B. However, even in such a case, it is important to shorten the power loop in the x direction as much as possible. In other words, it is desirable to arrange bypass capacitor 3 so that, in the plan view, the side parallel to the first direction is bisected into one portion 320 including one electrode 32 and other portion 310 including other electrode 31, one portion 320 includes a portion facing the one peripheral side of layered body 2, and other portion 310 includes a portion that does not face the one peripheral side of layered body 2 but faces an extension of the one peripheral side.

Further speaking of an arrangement of layered body 2 and bypass capacitor 3 in the plan view from the viewpoint of shortening the power loop in the x direction as much as possible, it is desirable to arrange bypass capacitor 3 so that one portion 320 including one electrode 32 entirely faces the one peripheral side of layered body 2 as shown in FIG. 10B, one portion 320 being obtained by bisecting the side parallel to the first direction. Such an arrangement makes it possible to shorten the power loop in the x direction without unreasonable wiring design.

That other portion 310 including other electrode 31 does not face the one peripheral side of layered body 2 has a meaning, other portion 310 being obtained by bisecting the side of bypass capacitor 3 parallel to the first direction. This is because the above-described arrangement produces an effect of shortening a connection path between other electrode 31 of bypass capacitor 3 and the upper element of layered body 2.

When the top surface of light-emitting element 100, which is the upper element of layered body 2, and Vin wiring 640 are connected by one or more wirings 500, arrangement positions and arrangement orientations of one or more wirings 500 are important in order to shorten the power loop as much as possible, the power loop leading from other electrode 31 (equivalent to the cathode at the time of current conduction) of bypass capacitor 3 to one electrode 32 (equivalent to the anode at the time of current conduction, connected to the power supply ground) of bypass capacitor 3 via layered body 2.

To bring wiring 500 down to a wiring on a mounting board, the wiring is required to be sufficiently large in area in consideration of a variation in position of wire bonding. Accordingly, when it comes to FIG. 10B and FIG. 11A, it is difficult to bring wiring 500 down to a position between layered body 2 and bypass capacitor 3 (i.e., bringing down in the y direction). Thus, bringing wiring 500 down in a direction in which bypass capacitor 3 is not disposed relative to layered body 2 increases efficiency in a mounting process. It is desirable to dispose wire bond 501 along, among peripheral sides of light-emitting element 100 orthogonal to the first direction in a plan view, a peripheral side closer to other electrode 31 of bypass capacitor 3. In addition, it is desirable to bring wiring 500 down to Vin wiring 640 in parallel to the first direction in the plan view.

At this time, to shorten wiring 500 as much as possible, both light-emitting element 100 and switching element 200 constituting layered body 2 are rectangular in shape and arranged so that corresponding peripheral sides are parallel to each other, and additionally light-emitting element 100, which is the upper element, is disposed closer to other electrode 31 side of bypass capacitor 3 in the first direction, on the top surface of switching element 200, which is the lower element. When it comes to FIG. 10B, light-emitting element 100 is disposed toward the -x direction on the top surface of switching element 200. Disposing light-emitting element 100 as above makes it possible to shorten wiring 500 parallel to the first direction.

It is also possible to select an arrangement as shown in FIG. 11B. In FIG. 11B, bypass capacitor 3 is arranged so that the side parallel to the first direction is parallel to and entirely faces the one peripheral side of layered body 2 in a plan view. Such an arrangement makes it possible to shorten a portion of the power loop parallel to the first direction at a maximum in the plan view. When the one peripheral side of layered body 2 is longer than the side of bypass capacitor 3 parallel to the first direction in the plan view, it is desirable to select the arrangement as shown in FIG. 11B. It is desirable to dispose wire bond 501 in a neighborhood of, among four corner portions in the plan view, a corner portion closest to other electrode 31 of bypass capacitor 3, on the top surface of light-emitting element 100, which is the upper element of layered body 2. In addition, it is desirable to bring wiring 500 down to Vin wiring 640 in a direction that forms an angle of 45 degrees with the first direction in the plan view. It should be noted that an angle wiring 500 forms with the first direction in the plan view is not limited to 45 degrees. The important thing is that wiring 500 is disposed toward other electrode 31 of bypass capacitor 3 to shorten the power loop including the wiring. Here, an angle each of one or more wirings 500 forms with the first direction may be greater than 0 degrees and less than 90 degrees.

It is also possible to select an arrangement as shown in FIG. 11C. In FIG. 11C, an arrangement orientation of light-emitting element 100, which is the upper element, is 45 degrees relative to switching element 200, which is the lower element, compared to FIG. 11B. Such an arrangement produces an effect of facilitating arrangement of wire bond 501 along one peripheral side on the top surface of light-emitting element 100. However, in FIG. 11C, there is a possibility that a margin when the upper element is mounted on the top surface of the lower element decreases, compared to a case (FIG. 11B) in which the periphery of the lower element is parallel to the periphery of the upper element in a plan view. In response, an area of the lower element may be slightly increased or an area of the upper element may be slightly decreased.

In the schematic diagrams shown in FIG. 11B and FIG. 11C, switching element 200, which is the lower element of layered body 2, has a portion overlapping Vin wiring 640 in a plan view. However, since switching element 200 is in contact with mounting board 600 only at positions of various electrode pads (partial perfectly circular shapes lightly indicated in the figures), and further the various electrode pads are in contact with mounting board 600 via solder joint component 400, portions other than the positions of the various electrode pads stay above mounting board 600 by a height of solder joint component 400. Moreover, in the case of a common printed circuit board, regions other than solder connection portions are covered with an insulating film referred to as a silk screen, and in particular covering a metal wiring with this silk screen also plays a role of preventing metallic oxidation. Accordingly, even if switching element 200 overlaps the wiring on mounting board 600 in a plan view, this does not immediately mean that switching element 200 is electrically in contact with the wiring.

Additionally, the schematic diagrams shown in FIG. 11B and FIG. 11C differ from those shown in FIG. 10B and FIG. 11A in that the four perfectly circular electrode pads included in switching element 200 are rotated by 45 degrees relative to a position of what is called pips for 4 on a dice. An effect of shortening the power loop may be expected by rearranging the positions of the electrode pads of switching element 200 in the above manner, depending on design of wirings disposed on mounting board 600.

A closest distance between bypass capacitor 3 and layered body 2 in the y direction will be described with reference to FIG. 10B. Although it is necessary to leave a minimum space between bypass capacitor 3 and layered body 2 to prevent a short circuit between elements, too much space therebetween leads to an increase in parasitic inductance of a wiring. FIG. 12 shows a magnitude relation between length (○) and width (Δ) of a metal wiring and parasitic inductance occurring in the metal wiring, when the metal wiring includes copper foil that is a typical material. The metal wiring has a thickness of 0.035 mm that is a wiring thickness in specification for a typical printed circuit board. The length (○) of the metal wiring is plotted when the metal wiring has a width of 0.5 mm, and the width (Δ) of the metal wiring is plotted when the metal wiring has a length of 1.0 mm. It is clear from FIG. 12 that parasitic inductance tends to increase with an increase in length of the metal wiring without saturating. In contrast, the parasitic inductance decreases with an increase in width of the metal wiring, but tends to saturate quickly and shows no remarkable amount of change at a width of approximately 0.5 mm or more. In the present disclosure relating to the light source module, the metal wiring on mounting board 600 often and typically has a width of at least 0.5 mm in consideration of the size of layered body 2 and bypass capacitor 3 used. On the other hand, the metal wiring is likely to be designed to have a length of approximately several millimeters in order to achieve the shape of mounting board 600, the size of each element, wiring connection according to a circuit diagram including peripheral circuits for other functions without any difficulty. For example, when the metal wiring has a length of 3.0 mm, parasitic inductance is approximately 1.8 nH.

The following describes parasitic inductance occurring outside the wiring of the power loop. Since current flows through a wide area inside light-emitting element 100, parasitic inductance tends to be low. As a typical example, the parasitic inductance is estimated to be 0.03 nH. It is typical to use a wiring having a diameter of 25 µm that connects light-emitting element 100 and the metal wiring, and it is possible to keep parasitic inductance occurring in the wiring low, by providing an enough number of wirings. As a typical example, when five wirings each having a diameter of 25 µm are used, parasitic inductance is estimated to be 0.02 nH. Use of CSP also makes it possible to keep parasitic inductance low inside switching element 200. As a typical example, the parasitic inductance is estimated to be 0.05 nH. Many bypass capacitors having low parasitic inductance are available on the market. As a typical example, the parasitic inductance is estimated to be 0.05 nH. In view of the above, a sum of the parasitic inductance except for the parasitic inductance due to the wiring is estimated to be 0.15 nH. A comparison between the typical examples and FIG. 12 clearly shows that the parasitic inductance occurring in the metal wiring has the value larger in digit than the values of the parasitic inductance occurring inside the element and the wiring. To put it another way, since the metal wiring is used for connecting bypass capacitor 3 and layered body 2 in the y direction, it is possible to shorten the metal wiring used, by shortening the power loop in the y direction. For this reason, shortening the power loop in the y direction has a profound effect of reducing parasitic inductance.

Table 1 below summarizes results of estimating parasitic inductance of a metal wiring necessary to achieve a square emission waveform with a steep rise.

**[Table 1]**

| | |
|---|---|
| Rise time | 5 ns |
| Total parasitic inductance | 0.5 nH |
| Parasitic inductance excluding parasitic inductance due to wiring | 0.15 nH |
| Parasitic inductance due to wiring | 0.35 nH |

The estimation for Table 1 was performed as follows. First, it was assumed necessary to set rise time of an emission waveform (defined as time when a peak value of the waveform changes from 10% to 90%) to 5 ns in an operation when a pulse width is 10 ns. Next, it was estimated that parasitic inductance in an entire power loop need be reduced to 0.5 nH. In the power loop, since parasitic inductance not due to the metal wiring was estimated to be approximately 0.15 nH as stated above, parasitic inductance due to the metal wiring need be reduced to 0.35 nH.

Metal wirings included in the power loop will be described with reference to FIG. 10B. First, one electrode 32 of bypass capacitor 3 and the lower element of layered body 2 are connected by a metal wiring via solder joint component 400. The metal wiring between these in a plan view is referred to as a first metal wiring. Next, other electrode 31 of bypass capacitor 3 and the upper element of layered body 2 are connected by a metal wiring via solder joint component 400 and one or more wirings 500 brought down from the top surface of layered body 2. The metal wiring between these in the plan view is referred to as a second metal wiring.

The following defines a length and a width of each of the first metal wiring and the second metal wiring specified in the plan view. Length L (mm) of the first metal wiring is considered to be equivalent to a closest distance between one electrode 32 of bypass capacitor 3 and layered body 2 in the second direction. Moreover, width W1 (mm) of the first metal wiring can be defined as maximum in the first direction in a region specified by above length L (mm) in the second direction.

Although, strictly speaking, the length of the second metal wiring is influenced by an arrangement position of wiring 500, it is natural that wiring 500 is brought down to a position as close to bypass capacitor 3 as possible. For this reason, it is safe to consider that the length of the second metal wiring is equal to length L (mm) of the first metal wiring. Moreover, width W2 (mm) of the second metal wiring can be defined as maximum in the first direction in a region specified by above length L (mm) in the second direction from other electrode 31 of bypass capacitor 3.

To reduce parasitic inductance regarding a metal wiring to 0.35 nH, it is necessary to appropriately select a length and a width of each of the first metal wiring and the second metal wiring. FIG. 13 shows results of calculation for a relation between a length and a width of a metal wiring as a conduction path, the metal wiring including copper foil with a thickness of 0.035 mm and having a parasitic inductance of 0.35 nH. Pairs of length and width of the metal wiring having the parasitic inductance of exactly 0.35 nH are plotted. An upper left region of the plot includes pairs of length L (mm) and width W (mm) of the metal wiring having a parasitic inductance less than 0.35 nH. Accordingly, it is desirable to select the length and width of each of the first metal wiring and the second metal wiring so that W (mm) ≥ 3.40 × L^2 - 1.32 × L + 0.12 is satisfied, where W (mm) denotes an average of width W1 (mm) of the first metal wiring and width W2 (mm) of the second metal wiring.

As stated above, the inventors examined the arrangements of layered body 2 and bypass capacitor 3 in a plan view to shorten the power loop formed by layered body 2 and bypass capacitor 3 as much as possible. (c) in FIG. 4 shows an emission waveform of semiconductor device (light source module) 1 in which layered body 2 and bypass capacitor 3 are arranged as shown in FIG. 10B to satisfy the above-described relation. The arrangement position of bypass capacitor 3 in (a) in FIG. 4 had not sufficiently shortened the power loop formed by layered body 2 and bypass capacitor 3. (c) in FIG. 4 for which the power loop is shortened with ingenuity shows that the rise of the emission waveform is clearly improved, and the emission waveform is getting close to a desired square waveform for the light source module.

Embodiment 6 has been described on the assumption that the upper element and the lower element of layered body 2 are light-emitting element 100 and switching element 200, respectively. For this reason, the power loop has been described as leading from other electrode 31 (equivalent to the cathode at the time of current conduction) of bypass capacitor 3 to one electrode 32 (equivalent to the anode at the time of current conduction, connected to the power supply ground) of bypass capacitor 3 via layered body 2. However, in the present disclosure, the upper element and the lower element of layered body 2 may be switching element 200 and light-emitting element 100, respectively. It should be noted that in this case, a corresponding power loop leads from one electrode 32 (equivalent to the cathode at the time of current conduction) of bypass capacitor 3 to other electrode 31 (equivalent to the anode at the time of current conduction, connected to the power supply ground) of bypass capacitor 3 via layered body 2.

Suppose that first bypass capacitor 3 is already arranged relative to layered body 2 so that a side of first bypass capacitor 3 parallel to a first direction is parallel to one peripheral side of layered body 2. When second bypass capacitor 3 of the same type is additionally arranged in such a case, it is inadvisable to select a place adjacent to first bypass capacitor 3 already arranged and on a side away from layered body 2 in a second direction orthogonal to the first direction for arranging second bypass capacitor 3. This is because second bypass capacitor 3 certainly ends up having a conduction path in the second direction (y direction) longer than a conduction path of first bypass capacitor 3. Instead of selecting such an arrangement, it is desirable to select an other peripheral side of layered body 2, and select to arrange second bypass capacitor 3 at a position that causes second bypass capacitor 3 not to differ significantly in length of a power loop from first bypass capacitor 3.

Accordingly, it is desirable to arrange bypass capacitor 3 so that a closest distance between layered body 2 and bypass capacitor 3 in the plan view be shorter than a side of bypass capacitor 3 parallel to the second direction. Such an arrangement makes it possible to prevent the power loop from getting longer due to the side-by-side arrangement of two or more bypass capacitors 3 in the second direction.

### [Embodiment 7]

As shown in FIG. 14A and FIG. 14B, layered body 2 and bypass capacitor 3 may be directly connected by wiring 500 in semiconductor device (light source module) 1. In a semiconductor device, wiring 500 usually comprises gold (Au), and a capacitor having an Au-plated terminal is selected for metal joining with a terminal (one electrode or an other electrode) of bypass capacitor 3. It should be noted that capacitors enabling direct bonding of an Au wiring to a terminal of such a chip-type capacitor are already available on the market (e.g., GMD series of Murata Manufacturing Co., Ltd.: Wire Bonding/AuSn Soldering Mount Chip Multilayer Ceramic Capacitors for General Purpose etc.). Since the top surfaces of layered body 2 and bypass capacitor 3 are connected to each other, it is desirable that a difference in height between layered body 2 and bypass capacitor 3 with respect to mounting board 600 be smaller in order to shorten wiring 500 as much as possible.

For example, when a configuration of layered body 2 is already determined, it is desirable to select bypass capacitor 3 having a height similar to a height of layered body 2. Moreover, when there are a plurality of bypass capacitors 3, instead of arranging in orientation as shown in FIG. 14A, it is desirable to rotate even one of the plurality of bypass capacitors 3 by 90 degrees as shown in FIG. 14B when such an arrangement reduces a difference in height from layered body 2. In other words, it is desirable to select an arrangement surface for bypass capacitor 3 so that the height of the top surface of bypass capacitor 3 is most similar to the height of the top surface of layered body 2. It should be noted that an arrangement surface is a surface of bypass capacitor 3 which is mounted onto mounting board 600 via solder joint component 400.

Likewise, when bypass capacitor 3 is determined in advance, it is desirable to adjust a height of layered body 2. At this time, although the height (thickness) of any one of light-emitting element 100 and switching element 200 may be adjusted, since increasing the thickness of switching element 200 leads to an increase in on resistance, it is more likely to keep characteristics from deteriorating when the thickness of light-emitting element 100 is adjusted. Furthermore, when a difference in height between layered body 2 and bypass capacitor 3 is large, it is desirable that one of layered body 2 and bypass capacitor 3 be designed to be located in a recess portion or a projection portion provided in part of mounting board 600 so that layered body 2 and bypass capacitor 3 have similar heights, that is, the top surfaces close to each other.

### [Embodiment 8]

A plurality of bypass capacitors 3 may be included for one layered body 2. FIG. 15B schematically illustrates an arrangement relation in a plan view when four bypass capacitors 3 of the same type having the same characteristics and connected in parallel are included for one layered body 2. Each bypass capacitor 3 is arranged so that a side of bypass capacitor 3 parallel to the first direction includes a portion parallel to and facing one peripheral side of layered body 2 in a plan view.

It is conceivable that each bypass capacitor 3 forms a power loop with light-emitting element 100 and switching element 200 constituting layered body 2, and the power loops are electrically parallel to each other. For that matter, in FIG. 15B, a state in which each of the plurality of bypass capacitors 3 is supplied and charged with electric charges from an unshown power supply when the plurality of bypass capacitors 3 are connected to layered body 2 is an initial state. When switching element 200 is turned on, electric charges from other electrode 31 (equivalent to the cathode at the time of current conduction) of each bypass capacitor 3 are transiently supplied to layered body 2 via a corresponding path, which leads to light emission. Moreover, a power loop formed by layered body 2 and each bypass capacitor 3 includes a path returning to one electrode 32 (equivalent to the anode at the time of current conduction, connected to the power supply ground) of bypass capacitor 3. It should be noted that, assuming that the same amount of electric charge is supplied to layered body 2, the amount of electric charge supplied by each of a plurality of bypass capacitors 3 is smaller when the plurality of bypass capacitors 3 are included than when only one bypass capacitor 3 is included. When four bypass capacitors 3 are included as shown in FIG. 15B, the amount of electric charge supplied by each of four bypass capacitors 3 can be designed to be approximately 1/4.

Arranging the plurality of bypass capacitors 3 and forming individual power loops have the advantage of reducing parasitic inductance. To obtain the greatest advantage, it is necessary to connect two or more even number of bypass capacitors 3 connected in parallel to one layered body 2, and to arrange, in a plan view, the two or more even number of bypass capacitors 3 in line-symmetric positions with respect to a line passing through the center of one layered body 2 as an axis.

FIG. 15B illustrates the effect of this arrangement. Suppose layered body 2 is at the center and assigning a number to each bypass capacitor in a counterclockwise direction starting from a bypass capacitor to the upper right of layered body 2 results in a first bypass capacitor (the upper right), a second bypass capacitor (the upper left), a third bypass capacitor (the lower left), and a fourth bypass capacitor (the lower right). When a line passing through the center of layered body 2 and parallel to the x direction is an axis, the first and second bypass capacitors and the third and fourth bypass capacitors are line-symmetrical to each other. When a line passing through the center of layered body 2 and parallel to the y direction is an axis, the first and fourth bypass capacitors and the second and third bypass capacitors are line-symmetrical to each other. The arrangement relation between layered body 2 and bypass capacitors 3 shown in FIG. 15B is line-symmetric in both the x-direction and the y-direction, and has high symmetry.

A direction in which current (electric charges) of a power loop formed by the first bypass capacitor and layered body 2 flows is clockwise (the right white arrow in FIG. 15B), and a magnetic field in the -z direction is generated according to the right-handed screw rule. In contrast, a direction in which current (electric charges) of a power loop formed by the second bypass capacitor and layered body 2 flows is counterclockwise (the left white arrow in FIG. 15B), and a magnetic field in the +z direction is generated. It is conceivable that the current of the two power loops is substantially same, and a combination of the opposite directions causes the magnetic fields generated in the respective power loops to cancel each other out. Since it is possible to make a magnetic field generated as a result smaller than when the effect of canceling out is absent, it is possible to reduce parasitic inductance generated due to the magnetic field. Similarly, a power loop formed by the third bypass capacitor and layered body 2 is clockwise, and a magnetic field in the -z direction is generated. In contrast, a power loop formed by the fourth bypass capacitor and layered body 2 is counterclockwise, and a magnetic field in the +z direction is generated. It is conceivable that the current of the two power loops is substantially same, and a combination of the opposite directions causes the magnetic fields generated in the respective power loops to cancel each other out. In consequence, it is possible to reduce parasitic inductance.

As stated above, when the two or more even number of bypass capacitors 3 connected in parallel are connected to one layered body 2 and are arranged, in the plan view, in the line-symmetric positions with respect to the line passing through the center of one layered body 2 as the axis, it is possible to cause the magnetic fields generated in the respective power loops to cancel each other out, the power loops each being formed by a corresponding one of the two or more number of bypass capacitors 3 and one layered body 2. Accordingly, it is possible to produce an effect of further reducing parasitic inductance, compared to a case in which only one bypass capacitor 3 is arranged.

At this time, as shown in FIG. 15B, in layered body 2, it is desirable to mount light-emitting element 100, which is the upper element, on the top surface of switching element 200, which is the lower element, in a position where the both elements are homocentric. Moreover, it is desirable that wirings 500 from the top surface of layered body 2 be brought down in both the -x direction and the +x direction and be arranged so that wirings 500 have the same length, thickness, count, etc. Furthermore, it is desirable to arrange an even number of wirings 500 so that each bypass capacitor 3 has an equivalent power loop. As stated above, it is also necessary to pay attention to the configuration of layered body 2 itself to achieve high symmetry so that the power loops associated with respective bypass capacitors 3 are equivalent to each other.

It is desirable that for symmetry in the arrangement relation between layered body 2 and bypass capacitor 3, at least symmetry in an arrangement relation between the lower element and bypass capacitor 3 be satisfied in a plan view. FIG. 15A shows a wiring design on mounting board 600 before layered body 2 and bypass capacitor 3 are arranged. GND wiring 630 and Vin wiring 640 are made longer so that an even number of bypass capacitors 3 can be arranged in line-symmetric positions with respect to layered body 2 as the center. Although not shown, gate wiring 610 is capable of transmitting an external control signal through a second wiring layer in a depth direction of mounting board 600. Additionally, in the example shown in FIG. 15B, switching element 200, which is the lower element, does not include drain electrode pad 270.

When a power loop associated with each bypass capacitor 3 is shortened as much as possible, it is also possible to select an arrangement as shown in FIG. 15C. In FIG. 15C, each bypass capacitor 3 is arranged so that a side of bypass capacitor 3 parallel to the first direction is parallel to and entirely faces one peripheral side of layered body 2 in the plan view. For this reason, it is safe to say that such an arrangement shortens each power loop most at least in the first direction. Moreover, since it is also possible to expect an effect of causing magnetic fields generated in the respective power loops to cancel each other out, it is safe to say that the arrangement is favorable to reduce parasitic inductance.

### [Embodiment 9]

FIG. 16 is a cross-sectional view and a schematic plan view of semiconductor device (light source module) 1 in Embodiment 9. The cross-sectional view of FIG. 16 shows a cross section along line A-A' in the plan view. In Embodiment 9, layered body 2 in which light-emitting element 100 is an upper element and switching element 200 is a lower element is disposed in recess portion 650 provided in part of mounting board 600. There is an advantage that a difference in height between a top surface of mounting board 600 and a bottom surface of recess portion 650 is substantially the same as a height of layered body 2. In such a case, since there is almost no difference in height when Vin wiring 641 on the top surface of mounting board 600 and a top surface of light-emitting element 100 in layered body 2 are connected by one or more wirings 500, it is possible to shorten the length of one or more wirings 500. Thus, this is effective in reducing parasitic inductance.

A power loop in Embodiment 9 is as follows. Current from other electrode 31 (equivalent to the cathode at the time of current conduction) of bypass capacitor 3 on the top surface of mounting board 600 flows into light-emitting element 100 via Vin wiring 641 also on the top surface of mounting board 600 and one or more wirings 500, which causes light-emitting element 100 to emit light. Light-emitting element 100 continues to emit light while the current conduction continues, that is, during a period in which the gate of switching element 200 is on. The current further reaches, from light-emitting element 100, switching element 200, GND wiring 632 on the bottom surface of recess portion 650 of mounting board 600, metal fill VIA 670, and additionally GND wiring 631 on the top surface of mounting board 600, and returns to one electrode 32 (equivalent to the anode at the time of current conduction, connected to the power supply ground) of bypass capacitor 3. It should be noted that VGS wiring 612 that transmits an external signal to the gate of switching element 200 is also disposed on the bottom surface of recess portion 650 of mounting board 600. VGS wiring 612 is connected to VGS wiring 611 disposed on the top surface of mounting board 600 through metal fill VIA 670 inside mounting board 600.

FIG. 16 shows the configuration of layered body 2 in which the upper element is light-emitting element 100 and the lower element is switching element 200. The configuration of layered body 2 may be reversed, with the result that the upper element is switching element 200 and the lower element is light-emitting element 100. Moreover, layered body 2 may include, as switching element 200, a vertical type trench MOSFET as shown in FIG. 2C or a lateral type MOSFET as shown in FIG. 6 or FIG. 7. Furthermore, a semiconductor integrated circuit element may be used as switching element 200.

### [Embodiment 10]

Mounting board 600 as described in Embodiment 9 makes a neighborhood of side wall 660 available for arranging bypass capacitor 3, side wall 660 being formed by a difference in height between a top surface of mounting board 600 and a bottom surface of recess portion 650. Bypass capacitor 3 may be arranged on the bottom surface of recess portion 650 so that one side surface of bypass capacitor 3 is in contact with side wall 660 formed by recess portion 650.

It is also possible to embed bypass capacitor 3 within mounting board 600. FIG. 17 shows one example. In FIG. 17, bypass capacitor 3 is arranged so that the first direction is parallel to a layering direction of layered body 2 disposed in recess portion 650. Other electrode 31 (equivalent to the cathode at the time of current conduction) of bypass capacitor 3 is connected to Vin wiring 641 disposed on the top surface of mounting board 600 via solder. Vin wiring 641 is connected to light-emitting element 100 via one or more wirings 500, and light-emitting element 100 emits light when the current passes through light-emitting element 100. The current further flows from light-emitting element 100 to one electrode 32 (equivalent to the anode at the time of current conduction, connected to the power supply ground) of bypass capacitor 3 via switching element 200 and GND wiring 632 disposed on the bottom surface of recess portion 650 of mounting board 600.

In terms of mounting technique, it is not easy to arrange bypass capacitor 3 in the vicinity of layered body 2 disposed on tabular mounting board 600 so that the first direction is parallel to the layering direction of layered body 2. The reason is that bypass capacitor 3 has a narrow base area on mounting board 600 and is upwardly elongated, so it is difficult to put bypass capacitor 3 stably. On the other hand, in Embodiment 10, by embedding bypass capacitor 3 in the neighborhood of side wall 660 of recess portion 650 of mounting board 600, it is possible to increase mechanical stability and also ensure a close distance to layered body 2.

It is desirable to arrange bypass capacitor 3 so that other electrode 31 is just exposed to the top surface of mounting board 600. The difference in height between the top surface of mounting board 600 and the bottom surface of recess portion 650 may be substantially equal to the length of a side of bypass capacitor 3 parallel to the first direction. Moreover, it is desirable that an uppermost surface of layered body 2 disposed in recess portion 650 be substantially equal in height to the top surface of mounting board 600. For this reason, a bottom surface of bypass capacitor 3 arranged inside mounting board 600 in a way that the first direction is parallel to the layering direction of layered body 2 need not be flush with a bottom surface of layered body 2. At this time, mounting board 600 may include a multistage configuration, and bypass capacitor 3 and layered body 2 may each be arranged on an appropriate bottom surface of mounting board 600 so that the top surfaces thereof conform.

Although the semiconductor device of the present disclosure has been described thus far based on Embodiments 1 to 10, the present disclosure is not limited to these embodiments. Forms obtained by various modifications to each of the embodiments that can be conceived by a person skilled in the art as well as other forms realized by combining some of the constituent elements in the embodiment are included in the scope of the present disclosure as long as they do not depart from the essence of the present disclosure. The invention however is only as defined in the appended claims.

### [Industrial Applicability]

The semiconductor device according to the present disclosure is widely applicable as a semiconductor device used for a light source module for distance measurement.

### [Reference Signs List]

1 semiconductor device (light source module)
2 layered body
3 bypass capacitor
31 other electrode (anode or power supply ground) of bypass capacitor
32 one electrode (cathode) of bypass capacitor
100 light-emitting element
101 one principal surface of light-emitting element
102 other principal surface of light-emitting element
111 quantum well structure of light-emitting element
200 switching element
201 one principal surface of switching element
202 other principal surface of switching element
210 drain region (semiconductor substrate)
211 low concentration impurity region (low concentration impurity layer)
212 source electrode and protective layer
213 drain extraction region
214 well layer
215 source region
216 gate electrode
217 insulating film
218 high concentration impurity region
220 drain electrode
250 source electrode pad
255 effective region
260 gate electrode pad
265 control region
270 drain electrode pad
275 drain extraction region
280 non-functional region
300 adhesive component
310 other portion of side of bypass capacitor
320 one portion of side of bypass capacitor
400 solder joint component
500 wiring
501 wire bond
600 mounting board (PCB or submount board)
610, 611, 612 gate wiring (VGS wiring, metal wiring)
620 drain wiring (metal wiring)
630, 631, 632 GND wiring (metal wiring)
640, 641 Vin wiring (metal wiring)
650 recess portion
660 side wall of recess portion
670 fill VIA
700 driver IC (semiconductor integrated circuit element)
710 gate driver circuit

## Claims

1. A semiconductor device of a hybrid type, comprising:
a light-emitting element (100); and
a semiconductor integrated circuit element (700) including a switching element (200) that is connected in series with the light-emitting element (100) and controls current conduction to the light-emitting element (100) in response to a control signal externally inputted; and
one bypass capacitor (3) that supplies electric charges to the light-emitting element (100) and the semiconductor integrated circuit element (700),
wherein the light-emitting element (100), the semiconductor integrated circuit element (700), and the one bypass capacitor (3) form a power loop,
the light-emitting element (100) and the switching element (200) constitute a layered body (2) in which respective principal surfaces of the light-emitting element (100) and the switching element (200) are layered in parallel and face-to-face,
the layered body (2) and the one bypass capacitor (3) are mounted on a same mounting board (600),
when, of the light-emitting element (100) and the switching element (200) constituting the layered body (2), the switching element (200) is mounted on the mounting board (600), and the light element (100) is mounted on a top surface of the switching element (200):
in a plan view of the semiconductor device (1), the light-emitting element (100) and the switching element (200) are rectangular in shape and arranged so that corresponding peripheral sides are parallel to each other; and
the one bypass capacitor (3) includes one electrode (32) connected to the switching element (200) and an other electrode (31) connected to the light-emitting element (100), and
when a direction from the one electrode (32) to the other electrode (31) inside the one bypass capacitor (3) is a first direction (x) in the plan view:
a side of the one bypass capacitor (3) parallel to the first direction is parallel to one peripheral side of the layered body (2);
of the side of the one bypass capacitor (2) parallel to the first direction, a portion faces the one peripheral side of the layered body (2); and
in the plan view, the light-emitting element (100) is disposed, on the top surface of the switching element (200), shifted from the center position of the switching element (200) in a direction towards the other electrode of the bypass capacitor (3),
wherein one or more wirings (500) are used for a connection path between an uppermost surface of the layered body (2) and the one bypass capacitor (3), and
when a direction orthogonal to the first direction (x) is a second direction (y), in the plan view, the one or more wirings (500) are parallel to the first direction (x) and extend to the mounting board (600) from a peripheral side of the light-emitting element (100) extending in the second direction (y), the peripheral side being closer to the other electrode (31) of the one bypass capacitor (3) than an other peripheral side of the light-emitting element (100) extending in the second direction (y).

2. The semiconductor device according to claim 1,
wherein the switching element included in the semiconductor integrated circuit element is a vertical field-effect transistor that includes a source electrode on one principal surface, a drain electrode on an other principal surface facing away from the one principal surface, and a channel in a direction from the one principal surface to the other principal surface.

3. The semiconductor device according to claim 1,
wherein
in the plan view, the light-emitting element has a diagonal shorter than a shorter side of the semiconductor integrated circuit element.

4. The semiconductor device according to claim 1,
wherein in the plan view, the light-emitting element has a diagonal longer than half a shorter side of the semiconductor integrated circuit element.

5. The semiconductor device according to claim 1,
wherein the semiconductor integrated circuit element is a discrete switching element.

6. The semiconductor device according to claim 1,
wherein in the plan view of the semiconductor device:
the light-emitting element (100) includes a non-functional region in a peripheral portion; and
the switching element (200) covers at least a portion of the non-functional region.

## Patentansprüche

1. Halbleitervorrichtung eines hybriden Typs, umfassend:
ein lichtemittierendes Element (100); und
ein integriertes Halbleiter-Schaltungselement (700), das ein Schaltelement (200) umfasst, das mit dem lichtemittierenden Element (100) in Reihe geschaltet ist und Stromleitung zu dem lichtemittierenden Element (100) als Reaktion auf ein extern eingegebenes Steuersignal steuert; und
einen Bypass-Kondensator (3), der dem lichtemittierenden Element (100) und dem integrierten Halbleiter-Schaltungselement (700) elektrische Ladungen zuführt,
wobei das lichtemittierende Element (100), das integrierte Halbleiter-Schaltungselement (700) und der eine Bypass-Kondensator (3) eine Leistungsschleife bilden,
das lichtemittierende Element (100) und das Schaltelement (200) einen geschichteten Körper (2) bilden, in dem jeweilige Hauptoberflächen des lichtemittierenden Elements (100) und des Schaltelements (200) parallel und einander gegenüber geschichtet sind,
der geschichtete Körper (2) und der eine Bypass-Kondensator (3) auf einer gleichen Montageplatte (600) montiert sind,
wenn von dem lichtemittierenden Element (100) und dem Schaltelement (200), die den geschichteten Körper (2) bilden, das Schaltelement (200) auf der Montageplatte (600) montiert ist und das Lichtelement (100) auf einer oberen Oberfläche des Schaltelements (200) montiert ist:
in einer Draufsicht der Halbleitervorrichtung (1) das lichtemittierende Element (100) und das Schaltelement (200) eine rechtwinklige Form aufweisen und derart eingerichtet sind, dass entsprechende Umfangsseiten parallel zueinander sind; und
der eine Bypass-Kondensator (3) eine Elektrode (32), die mit dem Schaltelement (200) verbunden ist, und eine andere Elektrode (31) umfasst, die mit dem lichtemittierenden Element (100) verbunden ist, und
wenn eine Richtung von der einen Elektrode (32) zur anderen Elektrode (31) im Inneren des einen Bypass-Kondensators (3) eine erste Richtung (x) in der Draufsicht ist:
eine Seite des einen Bypass-Kondensators (3) parallel zur ersten Richtung parallel zu einer Umfangsseite des geschichteten Körpers (2) ist;
von der Seite des einen Bypass-Kondensators (3) parallel zur ersten Richtung ein Abschnitt der einen Umfangsseite des geschichteten Körpers (2) zugewandt ist; und
in der Draufsicht das lichtemittierende Element (100) auf der oberen Oberfläche des Schaltelements (200), von der mittleren Position des Schaltelements (200) in einer Richtung hin zur anderen Elektrode des Bypass-Kondensators (3) verschoben angeordnet ist,
wobei eine oder mehrere Verdrahtungen (500) für einen Verbindungspfad zwischen einer obersten Oberfläche des geschichteten Körpers (2) und dem einen Bypass-Kondensator (3) verwendet werden, und
wenn eine Richtung orthogonal zur ersten Richtung (x) eine zweite Richtung (y) ist, in der Draufsicht, die eine oder mehreren Verdrahtungen (500) parallel zur ersten Richtung (x) sind und sich zur Montageplatte (600) von einer Umfangsseite des lichtemittierenden Elements (100) erstrecken, das sich in der zweiten Richtung (y) erstreckt, wobei die Umfangsseite näher an der anderen Elektrode (31) des einen Bypass-Kondensators (3) liegt als an einer anderen Umfangsseite des lichtemittierenden Elements (100), das sich in der zweiten Richtung (y) erstreckt.

2. Halbleitervorrichtung nach Anspruch **1,**
wobei das Schaltelement, das in dem integrierten Halbleiter-Schaltungselement enthalten ist, ein vertikaler Feldeffekttransistor ist, der eine Source-Elektrode an einer Hauptoberfläche, eine Drain-Elektrode an einer anderen Hauptoberfläche, die von der einen Hauptoberfläche abgewandt ist, und einen Kanal in einer Richtung von der einen Hauptoberfläche zur anderen Hauptoberfläche umfasst.

3. Halbleitervorrichtung nach Anspruch 1,
wobei
in der Draufsicht das lichtemittierende Element eine Diagonale aufweist, die kürzer als eine kürzere Seite des integrierten Halbleiter-Schaltungselements ist.

4. Halbleitervorrichtung nach Anspruch 1,
wobei in der Draufsicht das lichtemittierende Element eine Diagonale aufweist, die länger als die Hälfte einer kürzeren Seite des integrierten Halbleiter-Schaltungselements ist.

5. Halbleitervorrichtung nach Anspruch 1,
wobei das integrierte Halbleiter-Schaltungselement ein diskretes Schaltelement ist.

6. Halbleitervorrichtung nach Anspruch 1,
wobei in der Draufsicht der Halbleitervorrichtung:
das lichtemittierende Element (100) einen nicht-funktionalen Bereich in einem Umfangsabschnitt umfasst; und
das Schaltelement (200) mindestens einen Abschnitt des nicht-funktionalen Bereichs bedeckt.

## Revendications

1. Dispositif semi-conducteur de type hybride, comprenant :
un élément émetteur de lumière (100) ; et
un élément de circuit intégré semi-conducteur (700) comportant un élément de commutation (200) qui est connecté en série avec l'élément émetteur de lumière (100) et qui commande une conduction de courant vers l'élément émetteur de lumière (100) en réponse à un signal de commande entré en externe ; et
un condensateur de dérivation (3) qui fournit des charges électriques à l'élément émetteur de lumière (100) et à l'élément de circuit intégré semi-conducteur (700),
dans lequel l'élément émetteur de lumière (100), l'élément de circuit intégré semi-conducteur (700) et le condensateur de dérivation (3) forment une boucle d'alimentation,
l'élément émetteur de lumière (100) et l'élément de commutation (200) constituent un corps stratifié (2) dans lequel des surfaces principales respectives de l'élément émetteur de lumière (100) et de l'élément de commutation (200) sont stratifiées en parallèle et face à face,
le corps stratifié (2) et le condensateur de dérivation (3) sont montés sur une même carte de montage (600),
lorsque, parmi l'élément émetteur de lumière (100) et l'élément de commutation (200) constituant le corps stratifié (2), l'élément de commutation (200) est monté sur la carte de montage (600), et l'élément émetteur de lumière (100) est monté sur une surface du haut de l'élément de commutation (200) :
dans une vue en plan du dispositif semi-conducteur (1), l'élément émetteur de lumière (100) et l'élément de commutation (200) sont de forme rectangulaire et sont agencés de manière à ce que les côtés périphériques correspondants soient parallèles entre eux ; et
le condensateur de dérivation (3) comporte une électrode (32) connectée à l'élément de commutation (200) et une autre électrode (31) connectée à l'élément émetteur de lumière (100), et
lorsqu'une direction allant de la première électrode (32) à l'autre électrode (31) à l'intérieur du condensateur de dérivation (3) est une première direction (x) dans la vue en plan :
un côté du condensateur de dérivation (3) parallèle à la première direction est parallèle à un côté périphérique du corps stratifié (2) ;
du côté du condensateur de dérivation (3) parallèle à la première direction, une partie fait face au côté périphérique du corps stratifié (2) ; et
dans la vue en plan, l'élément émetteur de lumière (100) est disposé sur la surface du haut de l'élément de commutation (200) de manière à être décalé par rapport à la position centrale de l'élément de commutation (200) dans une direction vers l'autre électrode du condensateur de dérivation (3),
dans lequel un ou plusieurs câblages (500) sont utilisés pour un chemin de connexion entre la surface le plus en haut du corps stratifié (2) et le condensateur de dérivation (3), et
lorsqu'une direction orthogonale à la première direction (x) est une deuxième direction (y), dans la vue en plan, les un ou plusieurs câblages (500) sont parallèles à la première direction (x) et s'étendent jusqu'à la carte de montage (600) à partir d'un côté périphérique de l'élément émetteur de lumière (100) s'étendant dans la deuxième direction (y), le côté périphérique étant plus proche de l'autre électrode (31) du condensateur de dérivation (3) qu'un autre côté périphérique de l'élément émetteur de lumière (100) s'étendant dans la deuxième direction (y).

2. Dispositif semi-conducteur selon la revendication **1,**
dans lequel l'élément de commutation inclus dans l'élément de circuit intégré semi-conducteur est un transistor à effet de champ vertical qui comporte une électrode de source sur une surface principale, une électrode de drain sur une autre surface principale orientée à l'opposé de la première surface principale, et un canal dans une direction allant de la première surface principale à l'autre surface principale.

3. Dispositif semi-conducteur selon la revendication 1,
dans lequel
dans la vue en plan, l'élément émetteur de lumière a une diagonale plus courte qu'un côté plus court de l'élément de circuit intégré semi-conducteur.

4. Dispositif semi-conducteur selon la revendication 1,
dans lequel, dans la vue en plan, l'élément émetteur de lumière a une diagonale plus longue que la moitié d'un côté plus court de l'élément de circuit intégré semi-conducteur.

5. Dispositif semi-conducteur selon la revendication 1,
dans lequel l'élément de circuit intégré semi-conducteur est un élément de commutation discret.

6. Dispositif semi-conducteur selon la revendication 1,
dans lequel, dans la vue en plan du dispositif semi-conducteur :
l'élément émetteur de lumière (100) comporte une région non fonctionnelle dans une partie périphérique ; et
l'élément de commutation (200) couvre au moins une partie de la région non fonctionnelle.
